# EUROPEAN PATENT APPLICATION

(11) **EP 4 791 167 A1**
(43) Date of publication of application: **12.08.2026**
(21) Application number: 26156735.8
(22) Date of filing: 05.02.2026
(51) Int. Cl.: H10K 59/80, H10K 59/38, H10K 50/86, H10K 50/822

(54) **DISPLAY ELECTRODE HAVING OPENINGS THEREIN, DISPLAY DEVICE HAVING THE SAME AND ELECTRONIC DEVICE INCLUDING THE SAME BACKGROUND**

(30) Priority: 06.02.2025 KR 20250015294
(71) Applicant: Samsung Display Co., Ltd., Yongin-si, Gyeonggi-do 17113 (KR)
(72) Inventor: MAIDANCHUK, Ivan, 17113 Yongin-si (KR); SHIN, Jaiku, 17113 Yongin-si (KR)
(74) Representative: Marks & Clerk LLP

(57) **Abstract**

A display device includes a display area including emission areas, display elements which are respectively in the emission areas and configured to emit light of different colors, the display elements each including a pixel electrode, an intermediate layer, and an opposite electrode in which openings are defined, and an anti-reflection layer on the display elements, the anti-reflection layer including color filters respectively corresponding to the display elements. W a same emission area among the emission areas, sizes or shapes of the openings defined in the opposite electrode are different from each other together with a largest dimension among the openings which are in the same emission area being from about 1 micrometer to about 10 micrometers.

## Description

### BACKGROUND

### 1. Field

One or more embodiments relate to a device. More particularly, one or more embodiments relate to a display device and an electronic device including the same.

### 2. Description of the Related Art

Mobile electronic devices are widely used. Tablet personal computers (PCs) as well as miniaturized electronic devices such as mobile phones have been widely used as mobile electronic devices.

To support various functions, for example, to provide a user with visual information, such as images, such mobile electronic devices include a display device. As the parts configured to drive a display device have been miniaturized, the proportion of the display device in an electronic device has gradually increased such that a structure within the display device (or the electronic device) which is bendable to a preset angle from a flat state is under development.

### SUMMARY

Generally, when a display device including color filters operates, a reflected color band viewed due to external light may overlap a color band of displayed images. In this case, the display device and an electronic device including the same may not provide clear images of the displayed images. One or more embodiments include a display device capable of providing clear images and an electronic device including the same.

Additional aspects will be set forth in part in the description which follows and, in part, will be apparent from the description, or may be learned by practice of the presented embodiments of the disclosure.

According to one or more embodiments, a display device includes a substrate including a display area, a plurality of display elements disposed in the display area, each including a pixel electrode, an intermediate layer, and an opposite electrode sequentially stacked, and configured to emit light of different colors, and an anti-reflection layer disposed on the plurality of display elements and including a plurality of color filters respectively corresponding to the plurality of display elements, where the opposite electrode is disposed in a region corresponding to an emission area of each of the plurality of display elements, and includes a plurality of openings of which at least one of sizes and shapes thereof are different from each other, and a largest width of each of the plurality of openings is in a range of about 1 micrometer (µm) to about 10 micrometers (µm).

In an embodiment, at least two openings may be disposed in the emission area of each display element, and one of the at least two openings and the other of the at least two openings may differ in at least one of a size and a shape.

In an embodiment, the display device may further include an encapsulation layer disposed on the display element and including at least one inorganic encapsulation layer and at least one organic encapsulation layer.

In an embodiment, at least a portion of one of the organic encapsulation layer and the inorganic encapsulation layer may be inserted into a portion of at least one of the plurality of openings.

In an embodiment, the display device may further include a capping layer disposed between the opposite electrode and the encapsulation layer.

In an embodiment, at least a portion of the capping layer may be inserted inside at least one of the plurality of openings.

In an embodiment, the opening may have a hole shape.

In an embodiment, the display device may further include an upper planarization layer disposed on the opposite electrode.

In an embodiment, the opposite electrode may be disposed to entirely cover the display area.

In an embodiment, the anti-reflection layer may further include a light-blocking layer including a plurality of opening areas disposed to respectively correspond to the plurality of display elements.

According to one or more embodiments, an electronic device includes a display device including a substrate including a display area, a plurality of display elements disposed in the display area, each including a pixel electrode, an intermediate layer, and an opposite electrode sequentially stacked, and configured to emit light of different colors, and an anti-reflection layer disposed on the plurality of display elements and including a plurality of color filters respectively corresponding to the plurality of display elements, where the opposite electrode is disposed in a region corresponding to an emission area of each of the plurality of display elements, and includes a plurality of openings of which at least one of sizes and shapes thereof are different from each other, and a largest width of each of the plurality of openings is in a range of about 1 µm to about 10 µm.

In an embodiment, at least two openings may be disposed in the emission area of each display element, and one of the at least two openings and the other of the at least two openings may differ in at least one of a size and a shape.

In an embodiment, the display device may further include an encapsulation layer disposed on the display element and including at least one inorganic encapsulation layer and at least one organic encapsulation layer.

In an embodiment, at least a portion of one of the organic encapsulation layer and the inorganic encapsulation layer may be inserted into a portion of at least one of the plurality of openings.

In an embodiment, the display device may further include a capping layer disposed between the opposite electrode and the encapsulation layer.

In an embodiment, at least a portion of the capping layer may be inserted inside at least one of the plurality of openings.

In an embodiment, the opening may have a hole shape.

In an embodiment, the display device may further include an upper planarization layer disposed on the opposite electrode.

In an embodiment, the opposite electrode may be disposed to entirely cover the display area.

In an embodiment, the anti-reflection layer may further include a light-blocking layer including a plurality of opening areas disposed to respectively correspond to the plurality of display elements.

Aspects, features, and advantages other than the above described things will become apparent from the following detailed description of the invention, the accompanying drawings, and claims.

At least some of the above and other features of the invention are set out in the claims.

### BRIEF DESCRIPTION OF THE DRAWINGS

The above and other aspects, features, and advantages of embodiments of the disclosure will be more apparent from the following description taken in conjunction with the accompanying drawings, in which:
FIG. 1 is a block diagram of an electronic device according to an embodiment;
FIGS. 2 to 4 are schematic views of an electronic device according to various embodiments;
FIG. 5 is a schematic perspective view of an electronic device according to an embodiment;
FIG. 6 is a schematic exploded perspective view of the electronic device shown in FIG. 5;
FIG. 7A is a schematic plan view of a portion of a display device shown in FIG. 6;
FIG. 7B is a schematic side view of a portion of the display device shown in FIG. 7A;
FIG. 8 is a schematic plan view of a portion of the display device shown in FIG. 6;
FIG. 9 is a schematic circuit diagram of a sub-pixel circuit of a sub-pixel disposed in a display area shown in FIG. 8;
FIGS. 10A and 10B are schematic cross-sectional views of a portion of the display device shown in FIG. 6;
FIG. 11 is a schematic enlarged plan view of a portion of the display device disposed in a portion of the display area shown in FIG. 6;
FIGS. 12A and 12B are cross-sectional views of a display device taken along line B-B' of FIG. 11;
FIGS. 13A to 13H are schematic plan views of an opening shown in FIG. 11 according to embodiments;
FIGS. 14A and 14B are schematic cross-sectional views of a display device taken along line B-B' of FIG. 11; and
FIGS. 15A and 15B are schematic cross-sectional views of a display device taken along line B-B' of FIG. 11.

### DETAILED DESCRIPTION

Reference will now be made in detail to embodiments, examples of which are illustrated in the accompanying drawings, where like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b, and c" indicates only a, only b, only c, both a and b, both a and c, both b and c, all of a, b, and c, or variations thereof.

As the disclosure allows for various changes and numerous embodiments, embodiments will be illustrated in the drawings and described in the detailed description. Effects and features of the disclosure, and methods for achieving them will be clarified with reference to embodiments described below in detail with reference to the drawings. However, the disclosure is not limited to embodiments described below and may be implemented in various forms.

Hereinafter, embodiments will be described with reference to the accompanying drawings, where, like or corresponding elements are given like reference numerals when describing with reference to the drawings, and a repeated description thereof is omitted. Within the Figures and the text of the disclosure, a reference number indicating a singular form of an element may also be used to reference a plurality of the element.

In embodiments below, such terms as first and second are not used in a limited meaning and are used for the purpose of distinguishing one element from another.

In embodiments below, the singular expressions include the plural expressions unless the context clearly indicates otherwise.

It will be understood that the terms "comprise," or "comprising," as used herein specify the presence of stated features or components but do not preclude the addition of one or more other features or components.

In embodiments below, when a layer, region, or element is referred to as being related to another portion such as being "on" another portion, it may include not only a case where the layer, region, or element is directly on the other portion, but also a case where intervening layers, regions, or elements are disposed therebetween. In contrast, when a layer, region, or element is referred to as being related to another portion such as being "directly on" another portion, no intervening layer, region or element is disposed therebetween. For example, elements which are directly on each other or are contacting each other may form an interface (physically) therebetween.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

In an embodiment below, an x axis direction, a y axis direction and a z axis direction are not limited to the directions corresponding to three axes of the rectangular coordinate system, and may be interpreted in a broader sense including the same. For example, the x axis direction, y axis direction, and z axis direction may be perpendicular to one another, or may represent different directions which are not perpendicular to one another.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In the case where an embodiment may be implemented differently, a specific process order may be performed in the order different from the described order. As an example, two processes successively described may be simultaneously performed substantially or performed in the opposite order of the described order.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

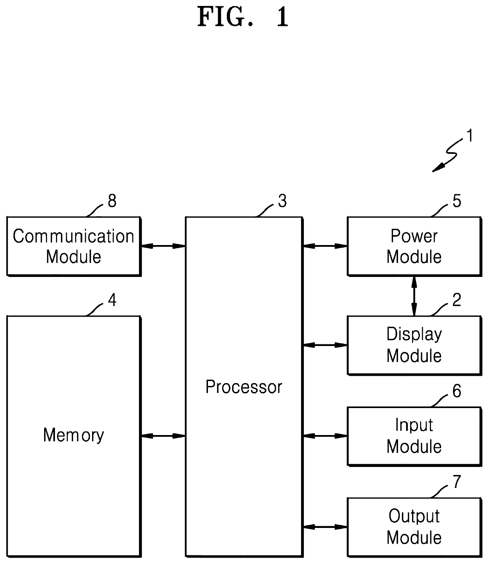

FIG. 1 is a block diagram of an electronic device 1 according to an embodiment.

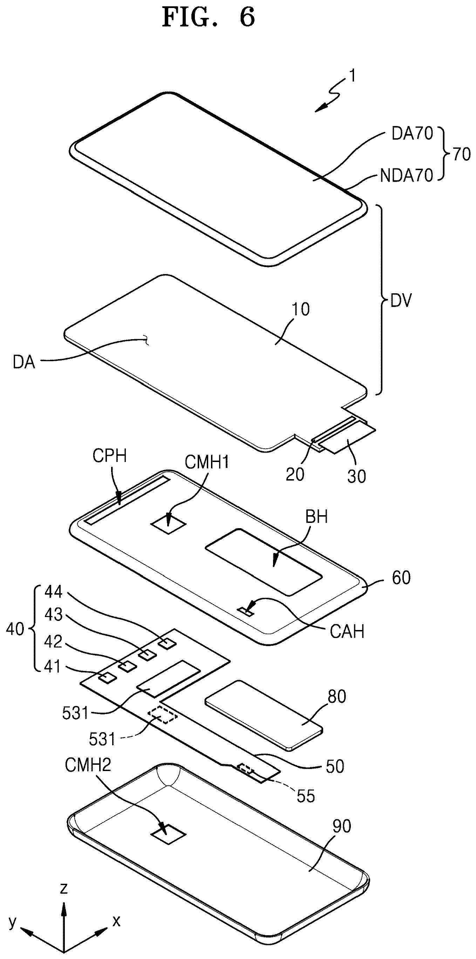

Referring to FIG. 1, the electronic device 1 according to an embodiment may include a display module 2, a processor 3, a memory 4, and a power module 5. The display module 2 may include one or more embodiment of a display panel 10(see FIG. 6).

The processor 3 may include at least one of a central processing unit (CPU), an application processor (AP), a graphic processing unit (GPU), a communication processor (CP), an image signal processor (ISP), and a controller. In an embodiment, the processor 3 may be divided into two or more portions in a functional or structural viewpoint. As an example, the processor 3 may include a main processor in the form of a first driving chip, including a central processing unit, and an auxiliary processor in the form of a second driving chip, including a controller, where the auxiliary processor receives image signals from the main processor and processes the image signals to match interface specifications of the display module 2.

The memory 4 may include at least one of a non-volatile memory and a volatile memory. The memory 4 may store data information required for operations of the processor 3 or the display module 2. When the processor 3 executes an application stored in the memory 4, an image data signal and/or an input control signal may be transferred to the display module 2, and the display module 2 may process a provided signal and output image information through a display screen.

The power module 5 may include a power supply module such as a power adapter or a battery unit, and a power converting module converting power supplied by the power supply module and generating power required for operations of the electronic device 1. Power conversion by the power converting module may include DC-DC conversion, AC-DC conversion, and DC-AC conversion and is not limited thereto.

The electronic device 1 may further include an input module 6, a non-image output module 7, and/or a communication module 8.

The input module 6 may provide input information to the processor 3 and/or the display module 2. The input module 6 may include not only a physical button, a keyboard, and a microphone, but also various kinds of sensor modules. Examples of the sensor modules may include not only touch sensors, pressure sensors, distance sensors, position sensors, digitizers, motion recognition sensors, camera sensors, photodetectors, photoelectric conversion sensors, temperature sensors, but also biometric sensors such as blood pressure sensors, blood sugar sensors, electrocardiogram sensors, and heart rate sensors.

The non-image output module 7 may receive information other than images received from the processor 3 and may provide the information to a user. Examples of the non-image output module 7 may include a sound module, a haptic module, and/or a light-emitting module, and include a unique functional module (e.g., a cooling module of a refrigerator) of other devices.

The communication module 8 is configured to transmit/receive information between the electronic device 1 and an external device and may include a receiver and a transmitter. The communication module 8 may include various wireless communication modules such as mobile communication modules, Wi-Fi (wireless fidelity) modules, and Bluetooth modules, and include various wired communication modules.

At least one of elements of the electronic device 1 may be included in a display device DV(see FIG. 6) according to the embodiments. In addition, some of modules mentioned-above may be included in the display device DV, and some other may be provided separately from the display device DV. As an example, the display device DV may include the display module 2, and the processor 3, the memory 4, and the power module 5 may be provided within the electronic device 1 instead of the display device DV. As another example, the power module 5 may be prepared in the display device DV, may provide power to the processor 3 and the memory 4 provided within the electronic device 1 instead of the display device DV, and is not limited thereto.

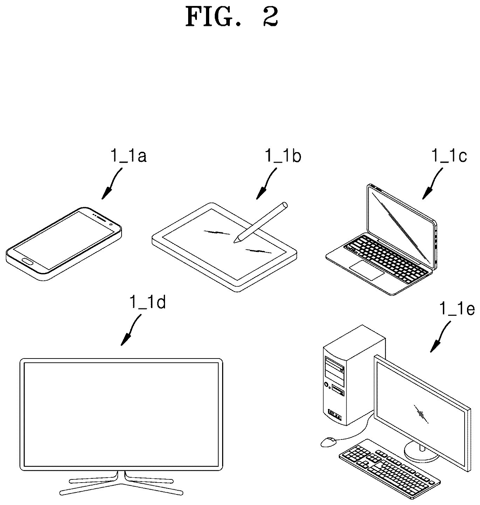

FIGS. 2 to 4 are schematic views of an electronic device 1 according to various embodiments. FIGS. 2 to 4 show examples of various electronic devices to which the display device DV according to embodiments is applied.

FIG. 2 shows, as an example of the electronic device 1, a smartphone 1_1a, a tablet personal computer 1_1b, a laptop 1_1c, a TV 1_1d, and a desk monitor 1_1e.

The smartphone 1_1a may include an input module such as a touch sensor, and a communication module in addition to the display module 2. The smartphone 1_1a may process information received through the communication module or other input modules and display the information through the display module 2 of the display device DV.

Similar to the smartphone 1_1a, the tablet personal computer 1_1b, the laptop 1_1c, the TV 1_1d, and the desk monitor 1_1e may include the display module 2 and the input module and may further include the communication module depending on an embodiment.

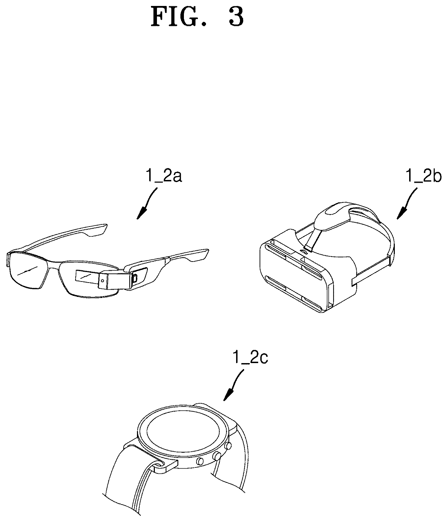

FIG. 3 shows, as an example, the case where the electronic device 1 including the display module 2 is applied to a wearable electronic device. The wearable electronic device may include a smart glasses 1_2a, a head mount display 1_2b, and a smartwatch 1_2c.

The smart glasses 1_2a and the head mount display 1_2b may include the display module 2 outputting display images through a display screen, and a reflector reflecting the output from the display screen. That is, the display module 2 may provide an image through the display screen to outside the electronic device 1, such as to a user. The display module 2 may provide an image of a virtual reality or an augmented reality to a user through the display screen.

The smartwatch 1_2c may include a biometric sensor as an input device and provide, through the display module 2, a user with bio information recognized through the biometric sensor.

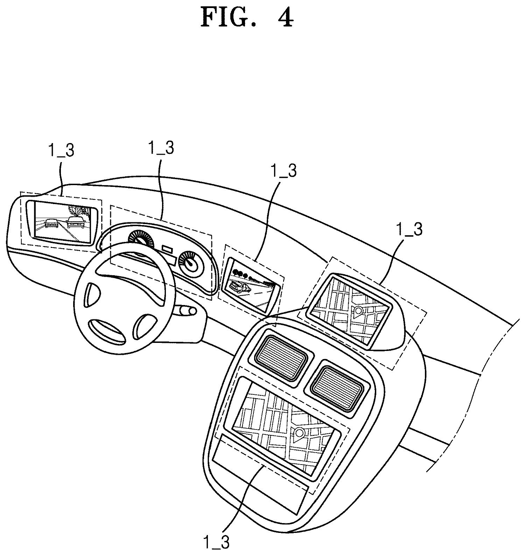

FIG. 4 shows, as an example, the case where the electronic device 1 including the display module 2 is applied to a vehicle. As an example, an electronic device 1_3 may be applied to an instrument board, a center facia or the like of an automobile, or may be applied to a center information display (CID) disposed on a dashboard of an automobile or a room mirror display replacing a side mirror.

Although not shown, the electronic device 1 to which the display device DV according to embodiments is applied may include not only devices centered on displays such as billboards, electronic boards, and/or game consoles, but also various home appliances which display information through a display module 2, such as a refrigerator, a washing machine, a dryer, an air conditioner, and/or a robot vacuum cleaner. In addition, in the case where the display module 2 has a function transmitting light, the display module 2 is applicable to an electronic device 1 such as a smart window or a transparent display device and the like, which display a background and a displayed image together with each other. The kind of the electronic device 1 according to an embodiment is not limited to the example, and various other electronic devices not shown as examples may be applied.

Hereinafter, for convenience of description, the case where the electronic device 1 is a smartphone is mainly described.

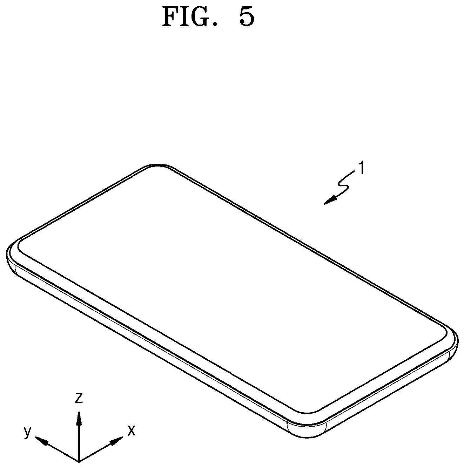

FIG. 5 is a schematic perspective view of the electronic device 1 according to an embodiment. FIG. 6 is a schematic exploded perspective view of the electronic device 1 shown in FIG. 5.

Referring to FIGS. 5 and 6, the electronic device 1 may include a display device DV including a cover window 70, a display panel 10, a data driver 20, and a display circuit board 30 as a first circuit board, a component 40, a bracket 60 as an intermediate cover, a main circuit board 50 as a second circuit board, a battery 80, and/or a lower cover 90.

In a plan view of the present specification, "left", "right", "up", and "down" denote directions when the display panel 10 is viewed in a direction perpendicular to the display panel 10, such as normal to a major surface thereof. As an example, "left" denotes a -x direction, "right" denotes a +x direction, "up" denotes a +y direction, and "down" denotes a -y direction.

The electronic device 1 may be shown to have a roughly rectangular shape in a plan view. As an example, as shown in FIG. 5, the electronic device 1 may have a roughly rectangular shape having short sides in an x axis direction and long sides in a y axis direction, in an xy-plane. The xy-plane may be defined by the x axis direction (as a first direction) and the y axis direction (as a second direction) crossing each other. A thickness of the electronic device 1, the display module 2, various components or layers thereof, etc. may be defined in a the direction normal (or perpendicular) to the xy-plane, such as along a z axis direction (as a third direction, e.g., a thickness direction).

In this case, an edge or periphery where a short side extended in the x axis direction meets a long side extended in the y axis direction may form a right angle or have a round shape with a preset curvature. In a plan view, the planar shape of the electronic device 1 is not limited to a rectangle, and may include other polygonal, elliptical, or irregular planar shapes.

The cover window 70 may be disposed on the display panel 10 to cover the upper surface of the display panel 10. The cover window 70 may protect the upper surface of the display panel 10.

The cover window 70 may include a transmissive cover portion DA70 and a light-blocking cover portion NDA70, where the transmissive cover portion DA70 corresponds to the display panel 10, and the light-blocking cover portion NDA70 is adjacent to the transmissive cover portion DA70. In an embodiment, the light-blocking cover portion NDA70 may surround the transmissive cover portion DA70, without being limited thereto. The light-blocking cover portion NDA70 may include an opaque material (e.g., a colored opaque material) which blocks light. The light-blocking cover portion NDA70 may include a pattern which is visible from outside the electronic device 1, such as to a user, when no image is displayed.

The display panel 10 may be disposed under the cover window 70. The display panel 10 may overlap (or face) the transmissive cover portion DA70 of the cover window 70. The display panel 10 may include a display area DA. The display area DA may overlap the transmissive cover portion DA70 and non-overlap the light-blocking cover portion NDA70, or may overlap both the transmissive cover portion DA70 and the light-blocking cover portion NDA70, The display area DA is a region (or planar area) in which images are displayed. The display area DA may include a region (referred to as a component area, hereinafter) within the overall planar area of the display area DA, at which light emitted from the component 40 disposed below the display panel 10 is transmitted into, through and/or from the display panel 10.

The component 40 as a functional component may include sensors and cameras which use visible light, infrared light, sound, and the like to provide a function to the electronic device 1.

The display panel 10 may be a light-emitting display panel including a light-emitting diode as a display element. The light-emitting diode may include an organic light-emitting diode including an organic material, or an inorganic light-emitting diode including an inorganic material. The inorganic light-emitting diode may include a PN-junction diode including inorganic material semiconductor-based materials. When a forward voltage is applied to a PN-junction diode, holes and electrons are injected, and light of a preset color may be emitted while energy created by recombination of the holes and the electrons is converted to light energy. The inorganic light-emitting diode may have a width of several micrometers to hundreds of micrometers. The inorganic light-emitting diode may be denoted by a micro light-emitting diode.

The display panel 10 may be a rigid display panel which has rigidity and thus is not easily bendable, foldable, or rollable, or a flexible display panel which has flexibility and thus is easily bendable, foldable, or rollable. As an example, the display panel 10 may include a foldable display panel which is foldable and unfoldable, a curved display panel which has a curved display surface, a bended display panel in which a region except a display surface is bent, a rollable display panel which is rollable and unrollable, or a stretchable display panel which is stretchable.

The display panel 10 may be implemented transparent and be a transparent display panel such that an object or background disposed below the display panel 10 at a lower surface thereof is viewable from the upper surface of the display panel 10. Alternatively, the display panel 10 may be a reflective display panel which may reflect an object or background disposed at the upper surface of the display panel 10.

The data driver 20 may be mounted in the form of an integrated circuit (IC) on the display panel 10. However, the disclosure is not limited thereto. As an example, the data driver 20 may be mounted on the display circuit board 30.

The display circuit board 30 may be attached to the display panel 10 at one side of the display panel 10. The display circuit board 30 may be a flexible printed circuit board (FPCB) which may be bent, a rigid printed circuit board (PCB) which is rigid and is not easily bendable, or a composite printed circuit board including both an FPCB and a rigid PCB. A touch sensor driver may be mounted on the display circuit board 30. The touch sensor driver may include an integrated circuit. The touch sensor driver may be electrically connected to touch electrodes of a touchscreen layer of the display panel 10 through the display circuit board 30.

The touchscreen layer of the display panel 10 may sense an external input such as a user's touch, by using at least one of various touch methods such as a resistance (electrical) layer method, a capacitance (electrical) method and the like. In the case where the touchscreen layer of the display panel 10 senses the external input by using a capacitance method, the touch sensor driver may determine whether the external input touches or approaches the touch sensor layer by applying driving signals to driving electrodes among touch electrodes, and sensing voltages charged in a mutual capacitance between the driving electrodes and the sensing electrodes through the sensing electrodes among the touch electrodes.

The external input may include a contact (e.g., physical or mechanical) touch and a proximity (non-contacting) touch. A contact touch denotes that a user's finger or an input tool such as a pen is in direct contact with the cover window 70 disposed on the touchscreen layer. A proximity touch, like hovering, denotes that a user's finger or an input tool such as a pen is located near over the cover window 70, at a distance away from the cover window 70 and non-contacting therewith. The touch sensor driver may be configured to transfer sensor data to a main processor according to sensed voltages, and the main processor may calculate a touch coordinate at which a touch input occurs by analyzing the sensor data.

A controller may be disposed on the display circuit board 30, where the controller is configured to supply driving voltages for driving pixels of the display panel 10, a gate driver, and/or the data driver 20.

The bracket 60 as an intermediate cover for supporting the display panel 10 may be disposed under the display panel 10. The bracket 60 may include plastic, metal, or both plastic and metal. The bracket 60 may have a first camera hole CMH1 defined therein and into which a camera device 531 is extended, a battery hole BH defined therein and in which the battery 80 is disposed, a cable hole CAH defined therein and through which a cable connected to the display circuit board 30 passes, and a component hole CPH defined therein corresponding to one or more of the components 40. The component hole CPH may overlap the components 40 of the main circuit board 50 when viewed in a third direction (z axis direction). For reference, the display area DA of the display panel 10 may overlap the components 40 of the main circuit board 50 when viewed in the third direction (z axis direction). When needed, the bracket 60 may not have the component hole CPH. Each of the holes described above may extend completely through a body of the bracket 60, such as to be open at both an upper surface and a lower surface thereof, without being limited thereto.

The components 40 of the electronic device 1 may include a first component 41, a second component 42, a third component 43, and a fourth component 44 which each overlap the display panel 10. Each of the first component 41, the second component 42, the third component 43, and the fourth component 44 may include at least one of a proximity sensor, an illumination sensor, an iris sensor, a face recognition sensor, and a camera (or an image sensor). A proximity sensor which uses an infrared ray may detect an object like an input tool which is located close to the upper surface of the electronic device 1, and an illumination sensor may detect brightness of external light incident to the upper surface of the electronic device 1. In addition, an iris sensor may capture an image of a body part such as a person's (eye) iris which is located over the upper surface of the electronic device 1, and a camera may receive image data of an object disposed at or facing the upper surface of the electronic device 1. The components 40 are not limited to the proximity sensor, the illumination sensor, the iris sensor, the face recognition sensor, and the camera, and may include other sensors.

The main circuit board 50 and the battery 80 may be disposed under the bracket 60. The main circuit board 50 may be a rigid printed circuit board or a flexible printed circuit board.

The main circuit board 50 may include the main processor, the camera device 531, a main connector 55, and the components 40. The main processor may include an integrated circuit. When needed, the electronic device 1 may include not only the camera device 531 disposed on the upper surface of the main circuit board 50 but also a camera device 531 disposed on the lower surface of the main circuit board 50 which is opposite to the upper surface. Each of the main processor and the main connector 55 may be disposed on one of the upper surface and the lower surface of the main circuit board 50. The main circuit board 50 may be electrically connected to the display circuit board 30 through the main connector 55 and the like.

The main processor may be configured to control all functions of the electronic device 1. As an example, the main processor may be configured to output digital video data to the data driver 20 through the display circuit board 30 such that the display panel 10 displays images. The main processor may be configured to receive sensed data from the touch sensor driver. The main processor may determine whether an external input such as from a user directly touches or approaches the touchscreen according to sensed data, and execute an operation corresponding to a user's direct touch or proximity touch. The main processor may be an application processor including an integrated circuit, a central processing unit, or a system chip.

The camera device 531 processes image frames such as still images or moving images obtained by an image sensor in a camera mode, and outputs the image frames to the main processor. The camera device 531 may include at least one of a camera sensor (e.g., a charge-coupled device (CCD), a complementary metal oxide semiconductor (CMOS), and the like), a photo sensor (or an image sensor), and a laser sensor.

A cable passing through the cable hole CAH of the bracket 60 may be connected to the main connector 55, and the main circuit board 50 may be electrically connected to the display circuit board 30 through this cable.

The electronic device 1 may be represented to include, though not shown in the drawing, a wireless communication unit, an input unit, a sensor unit, an output unit, an interface unit, a memory, and/or a power supply unit in addition to the main processor.

The wireless communication unit may include at least one of a broadcasting receiving module, a mobile communication module, a wireless Internet module, a short-range communication module, and a location information module.

The broadcasting receiving module is configured to receive broadcasting signals and/or broadcasting-related information from an external broadcasting management server through a broadcasting channel. The broadcasting channel may include satellite channels or groundwave channels.

The mobile communication module is configured to transmit/receive wireless signals to/from at least one of a base station, an external terminal, and a server on a mobile communication network established according to technology standards for mobile communication or communication schemes (e.g., Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access(HSUPA), Long Term Evolution (LTE), Long Term Evolution-Advanced (LTE-A), and the like). Wireless signals may include a voice call signal, an image communication call signal, or various types of data corresponding to text/multi-media message transmission/reception.

The wireless Internet module denotes a module for wireless Internet access. The wireless Internet module may be configured to transmit/receive radio signals on a communication network according to wireless Internet technologies. Examples of wireless Internet technologies may include wireless local area network (WLAN), wireless-fidelity (Wi-Fi), Wi-Fi Direct, and/or digital living network alliance (DLNA).

The short-range communication module is for short-range communication, and may support short-range communication by using at least one of Bluetooth^{®}, Radio Frequency Identification (RFID), Infrared Data Association (IrDA), Ultra Wideband (UWB), ZigBee (RTM), Near Field Communication (NFC), Wi-Fi, Wi-Fi Direct, and Wireless Universal Serial Bus (Wireless USB) technologies. The short-range communication module may support wireless communication between the electronic device 1 and a wireless communication system, between the electronic device 1 and another electronic device, or between the electronic device 1 and a network in which another electronic device (or an external server) is located, through a short-range wireless area network. The short-range wireless area network may be a wireless personal area network. The other electronic device may be a wearable device which may exchange data, or operate with the electronic device 1.

The location information module, which is a module for obtaining a location of the electronic device 1, may include a global positioning system (GPS) module or a Wi-Fi module.

The input unit may include an image input unit such as the camera device 531 for inputting image signals, a sound input unit such as a microphone for inputting sound signals, and the input unit for receiving information from outside the electronic device 1 such as from a user. The camera device 531 processes image frames such as still images or moving images obtained by an image sensor in an image communication mode or a capturing mode. The processed image frames may be displayed on the display panel 10 or stored in the memory. The microphone processes external sound signals as electrical voice data. The processed voice data may be variously utilized according to a function (or an application in execution) being performed in the electronic device 1.

The main processor may control an operation of the electronic device 1 to correspond to information input through the input unit. The input unit may include a mechanical input means such as buttons, a dome switch, a jog wheel, a jog switch, and the like, or a touch input means located on the lower surface or the lateral surface of the electronic device 1. The touch input means may include a touchscreen layer of the display panel 10.

The sensor unit may include at least one sensor which senses at least one of information inside the electronic device 1, peripheral environmental information surrounding the electronic device 1, and user information, and generates sensing signals corresponding thereto. The main processor may control driving or an operation of the electronic device 1 based on the sensing signals, or perform data processing, a function, or an operation related to an application installed in the electronic device 1. The sensor unit may be a proximity sensor, an illumination sensor, or a face recognition sensor as described above with regard to the component 40. The sensor unit may include an acceleration sensor, a magnetic sensor, a G-sensor, a gyroscope sensor, a motion sensor, an RGB sensor, an infrared (IR) sensor, a finger scan sensor, an ultrasonic sensor, an optical sensor, and/or a battery gauge. In addition, the sensor unit may include an environmental sensor or a chemical sensor. The environmental sensor may include, for example, a barometer, a hygrometer, a thermometer, a radiation detection sensor, a heat detection sensor, and/or a gas detection sensor. Chemical sensors may include, for example, an electronic nose, a healthcare sensor, and/or a biometric recognition sensor.

The output unit is intended to generate an output related to vision, hearing, or tactile sensation, and may include at least one of the display panel 10, a sound output unit, a haptic module, and a light output unit.

The display panel 10 displays (outputs) information processed by the electronic device 1. As an example, the display panel 10 may display execution screen information of an application driven by the electronic device 1, a user interface (UI), or graphic user interface (GUI) information corresponding to the execution screen information. The display panel 10 may include a display layer and a touchscreen layer, where the display layer displays images, and the touchscreen layer senses a user's touch input. Accordingly, the display panel 10 may serve as one of input devices which provide an input interface between the electronic device 1 and a user, and simultaneously, serve as one of output devices which provide an output interface between the electronic device 1 and a user.

The sound output unit may output sound data received by the wireless communication unit or stored in the memory in a call reception mode, a communication mode, a recoding mode, a voice recognition mode, and/or a broadcasting reception mode, and the like. The sound output unit may output sound signals related to a function (e.g., a call signal reception tone, a message reception tone, and the like) performed by the electronic device 1. The sound output unit may include a receiver and a speaker. At least one of the receiver and the speaker may be a sound generator which is attached under the display panel 10 and vibrates the display panel 10 to output sounds. The sound generator may be a piezoelectric element or a piezoelectric actuator which contracts and expands according to electrical signals, or an exciter which generates magnetic force by using a voice coil to vibrate the display panel 10.

The haptic module generates various haptic effects which may be felt by a user. The haptic module may provide vibrations to a user as a haptic effect. The haptic module may not only transfer a tactile effect through a direct contact but also implement a tactile effect such that a user may feel the tactile effect through a muscle sense in fingers or arms.

The light output unit outputs signals for informing occurrence of an event by using light of a light source. Examples of an event generated in the electronic device 1 may include message reception, call signal reception, a missed call, alarm, schedule notification, e-mail reception, and/or information reception through an application, and the like. Signals output by the light output unit are implemented when the electronic device 1 emits light of a single color or a plurality of colors to the front surface or the rear surface. The signal output may end when the electronic device 1 detects that a user confirms an event.

The interface unit serves as a path with various kinds of external devices connected to the electronic device 1. The interface unit may include at least one of a wired/wireless headset port, an external charger port, a wired/wireless data port, a memory card port, a port for connecting an apparatus having an identification module, an audio input/output (I/O) port, a video I/O port, and an earphone port. When an external apparatus is connected to the interface unit, the electronic device 1 may perform an appropriate control related to the external apparatus connected.

The memory stores data which support various functions of the electronic device 1. The memory may store a plurality of application programs driven in the electronic device 1, data and/or commands for operations of the electronic device 1. At least some of a plurality of applications may be downloaded from an external server through wireless communication. The memory may store an application program for operations of the main processor, and temporarily store data input/output, for example, data such as a phone book, messages, still images, and/or moving images. In addition, the memory may be configured to store haptic data for vibration of various patterns provided to the haptic module, and sound data related to various sounds provided to the sound output unit.

The memory may include at least one type of storing medium among a flash memory type, a hard disk type, a solid state disk (SSD) type, a silicon disk drive (SDD) type, a multimedia card micro type, a card type memory (e.g., secure digital (SD) or extreme digital (XD) memory), a random access memory (RAM), a static random access memory (SRAM), a read-only memory (ROM), an electrically erasable programmable read-only memory (EEPROM), a programmable read-only memory (PROM), a magnetic memory, a magnetic disk, and an optical disk.

The power supply unit receives an external power and/or an internal power under control of the main processor, and supplies power to respective elements included in the electronic device 1. The power supply unit may include the battery 80. In addition, the power supply unit may include a connection port. The connection port may be an example of the interface unit to which an external charger is electrically connected, where the external charger supplies power to charge the battery 80. Alternatively, the power supply unit may charge the battery 80 wirelessly. The battery 80 may be disposed not to overlap the main circuit board 50 in the third direction (the z axis direction). The battery 80 may overlap the battery hole BH of the bracket 60.

The lower cover 90 may form an exterior of the electronic device 1 and have an opening defined therein and exposing a portion of the display panel 10 to outside the lower cover 90. The lower cover 90 has an open shape corresponding to the display panel 10 and may be fastened to the display panel 10. That is, the lower cover 90 may define a receiving space or groove which is open in a direction towards the display panel 10 as shown in FIG. 6. The lower cover 90 may be located on the opposite side of the cover window 70 with the display panel 10 therebetween. The lower cover 90 may be disposed under the main circuit board 50 and the battery 80. The lower cover 90 may be fastened and fixed to the bracket 60. The lower cover 90 may form the lower exterior of the electronic device 1. The lower cover 90 may include plastic, metal, or both plastic and metal.

A second camera hole CMH2 through which the lower surface of the camera device 531 is exposed to outside the lower cover 90 may be formed in the lower cover 90. The positions of the camera device 531 and the first and second camera holes CMH1 and CMH2 corresponding to the camera device 531 are not limited to the embodiment shown in FIG. 6, but may be variously modified.

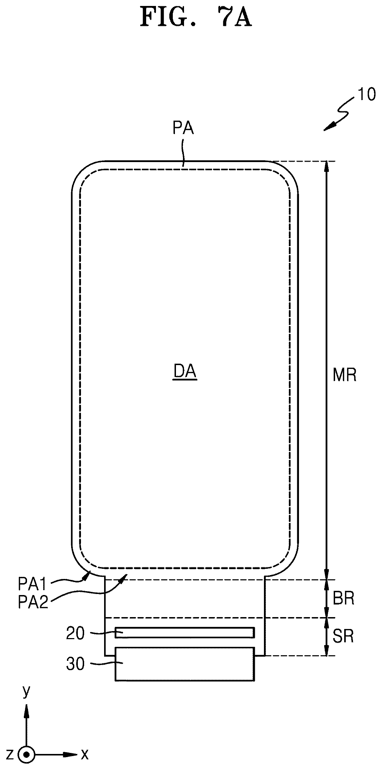

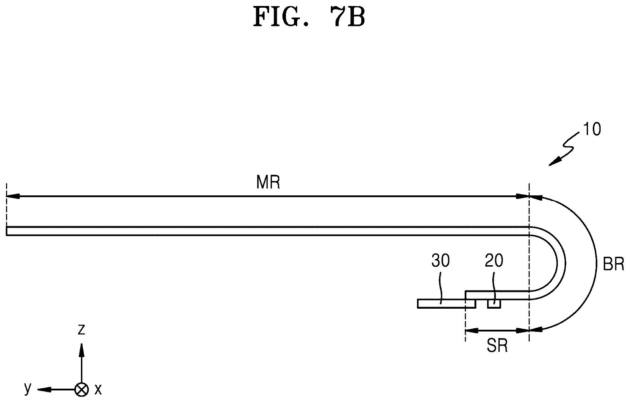

FIG. 7A is a schematic plan view of a portion of the display device DV shown in FIG. 6. FIG. 7B is a schematic side view of a portion of the display device DV shown in FIG. 7A. The electronic device 1 may include a portion of the display device DV shown in FIGS. 7A and 7B.

Referring to FIGS. 7A and 7B, the display device DV may include the cover window 70(see FIG. 6), the display panel 10, the data driver 20, and the display circuit board 30.

The display panel 10 may include the display area DA and a peripheral area PA which is outside the display area DA. The display area DA is a region in which images are displayed and a plurality of pixels may be disposed. The display area DA may have various planar shapes, for example, circular shapes, elliptical shapes, polygonal shapes, or shapes of specific figures. It is shown in the embodiment of FIG. 7A that the display area DA has a roughly rectangular shape having round corners.

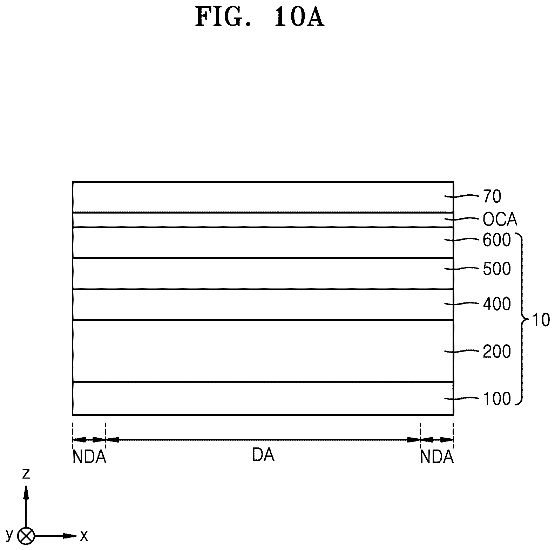

The peripheral area PA may be located outside and adjacent to the display area DA. The peripheral area PA may be a planar area in which images are not displayed, e.g., a non-display area NDA(see FIG. 10A). The peripheral area PA may include a first peripheral area PA1 and a second peripheral area PA2, where the first peripheral area PA1 is disposed to surround at least a portion of the display area DA, and the second peripheral area PA2 is located at the lower end of the display area DA and extends to have a major dimension in a first direction (e.g., an x axis direction). The width of the second peripheral area PA2 in the first direction (e.g., the x axis direction) may be less than the width of the display area DA in the first direction (e.g., the x axis direction). At least a portion of the second peripheral area PA2 may be easy to bend through this structure.

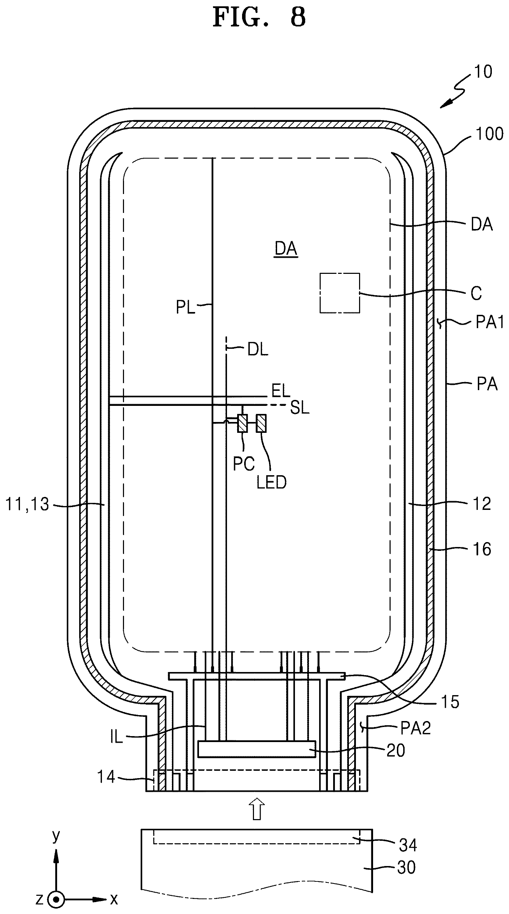

A planar shape of the display panel 10 shown in FIG. 7A may be substantially equal to the shape of the substrate 100(see FIG. 8) included in the display panel 10. When the display panel 10 includes the display area DA and the peripheral area PA which is outside the display area DA, it may represent the substrate 100 includes the display area DA and the peripheral area PA which is outside the display area DA. Hereinafter, for convenience, description is made on the assumption that the substrate 100 includes the display area DA and the peripheral area PA.

The display panel 10 may include a main region MR, a bent region BR outside the main region MR, and a sub-region SR spaced apart from the main region MR with the bent region BR therebetween. The main region MR may be disposed on one side of the bent region BR, and the sub-region SR may be disposed on the other side of the bent region BR. As shown in FIG. 7B, the display panel 10 may be bent in the bent region BR, and when viewed from a third direction (e.g., a z axis direction), at least portion of the sub-region SR may overlap the main region MR. Although it is shown in FIG. 7B that the display panel 10 is bent, the disclosure is not limited thereto. As an example, the display panel 10 may be a foldable display panel, and in this case, the display panel 10 may be bent within the display area DA around a bending axis crossing the display area DA. When needed, the display panel 10 may not be bent.

Among the bent region BR and the sub-region SR, the bent region BR and/or the sub-region SR may be a non-display area NDA, without being limited thereto. The second peripheral area PA2 may include the bent region BR and/or the sub-region SR, without being limited thereto.

The data driver 20 may be disposed in the sub-region SR of the display panel 10. The data driver 20 may be disposed in the form of an integrated circuit (IC) on the display panel 10. As an example, the data driver 20 may be a data driving integrated circuit generating data signals.

A display circuit board 30 may be attached to the display panel 10 at the end of the sub-region SR of the display panel 10. The display circuit board 30 may be electrically connected to the data driver 20 or the like through a pad of the sub-region SR of the display panel 10.

FIG. 8 is a schematic plan view of a portion of the display device DV shown in FIG. 6.

Referring to FIG. 8, the display panel 10 may include the substrate 100. Various elements forming the display panel 10 may be disposed on the substrate 100.

The substrate 100 may include glass, ceramic, metal, or polymer resin. The substrate 100 may include polymer resin such as polyethersulphone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multi-layered structure including two layers including the above-described polymer resin, and an inorganic material layer disposed therebetween. Alternatively, the substrate 100 may have a structure in which a layer including the polymer resin and an inorganic material layer are alternately stacked. The inorganic material layer may include, for example, silicon oxide, silicon nitride, or silicon oxynitride.

Sub-pixels may be disposed in the display area DA, and the display area DA may display images using light emitted from the sub-pixels. A group of sub-pixels may be provided in a pixel. Each sub-pixel may include a light-emitting diode LED, which is a display element, and a sub-pixel circuit PC electrically connected to the light-emitting diode LED. The sub-pixel circuit PC and the light-emitting diode LED may be disposed in the display area DA. For convenience, although it is shown in FIG. 8 that the sub-pixel circuit PC and the light-emitting diode LED are located side-by-side, the sub-pixel circuit PC may actually at least partially overlap the light-emitting diode LED. As an example, the light-emitting diode LED may be disposed on the sub-pixel circuit PC.

A gate driving circuit, a pad 14, a first power supply line 15, and a second power supply line 16 may be disposed in the peripheral area PA. The gate driving circuit may include, for example, a first scan driving circuit 11, a second scan driving circuit 12, and/or an emission control driving circuit 13.

The first scan driving circuit 11 may be configured to provide scan signals to the sub-pixel circuit PC through a scan line SL. The second scan driving circuit 12 may be disposed opposite the first scan driving circuit 11 with the display area DA therebetween. Some of the sub-pixel circuits PC disposed in the display area DA may be electrically connected to the first scan driving circuit 11, and the others may be connected to the second scan driving circuit 12. Depending on a case, the second scan driving circuit 12 may be omitted.

Like the first scan driving circuit 11, the emission control driving circuit 13 may be disposed on one side of the display area DA. The emission control driving circuit 13 may provide emission control signals to a pixel through an emission control line EL. Although it is shown in FIG. 8 that the emission control driving circuit 13 is disposed on only one side of the display area DA, the present invention is not limited thereto. For example, the display panel 10 may include the emission control driving circuits 13 disposed on one side and another side of the display area DA. Alternatively, the display panel 10 may include the first scan driving circuit 11 disposed on one side of the display area DA, and the emission control driving circuit 13 disposed on the other side of the display area DA.

The pad 14 as a display pad may be disposed in the second peripheral area PA2 of the substrate 100. The pad 14 may be exposed to outside the display panel 10 by not being covered by an insulating layer of the display panel 10. The display panel 10 may be electrically connected to the display circuit board 30 at the pad 14. A pad 34 as a circuit board pad of the display circuit board 30 may be electrically connected to the pad 14 of the display panel 10.

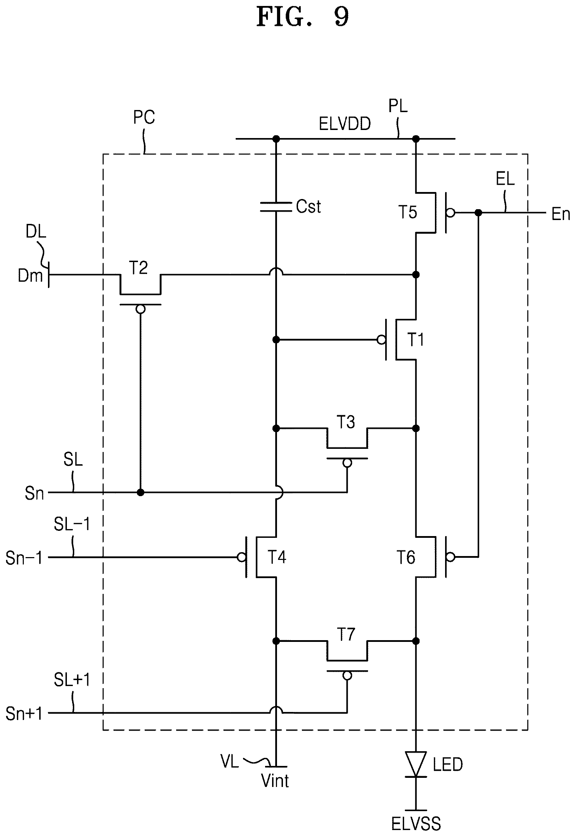

The display circuit board 30 is configured to transfer signals or power of a controller to the display panel 10. Control signals generated by the controller may be transferred to the gate driving circuit through the display circuit board 30. In addition, the controller may provide a first power voltage ELVDD(see FIG. 9) and a second power voltage ELVSS(see FIG. 9) to the first power supply line 15 and the second power supply line 16, respectively. The first power voltage ELVDD (also referred to as a driving voltage) may be provided to each sub-pixel circuit PC through a driving voltage line PL connected to the first power supply line 15, and the second power voltage ELVSS (also referred to as a common voltage) may be provided to a common electrode of the light-emitting diode LED connected to the second power supply line 16. The first power supply line 15 may extend in the first direction (the x axis direction). The second power supply line 16 may have a loop shape having one open side and partially surround the display area DA.

Data signals of the data driver 20 may be transferred to the sub-pixel circuit PC through a data line DL electrically connected to an input line IL through the input line IL.

FIG. 9 is a schematic circuit diagram of the sub-pixel circuit PC of a sub-pixel disposed in a display area DA shown in FIG. 8.

Referring to FIG. 9, the light-emitting diode LED may be electrically connected to the sub-pixel circuit PC.

The sub-pixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

The second thin-film transistor T2 is a switching thin-film transistor, may be connected to the scan line SL and the data line DL, and configured to transfer a data voltage (or a data signal Dm) to the first thin-film transistor T1 based on a switching voltage (or a scan signal Sn), the data voltage being input from the data line DL, and the switching voltage being input from the scan line SL. The storage capacitor Cst may be connected to the first thin-film transistor T1 and the driving voltage line PL and configured to store a voltage corresponding to a difference between a voltage transferred from the second thin-film transistor T2 and the first power voltage ELVDD supplied to the driving voltage line PL.

The first thin-film transistor T1 is a driving thin-film transistor, may be connected to the driving voltage line PL and the storage capacitor Cst, and configured to control a driving current according to the voltage stored in the storage capacitor Cst, the driving current flowing from the driving voltage line PL to the light-emitting diode LED. The light-emitting diode LED may be configured to emit light having a preset brightness corresponding to the driving current. A second electrode (e.g., a cathode) of the light-emitting diode LED may receive the second power voltage ELVSS.

The third thin-film transistor T3 is a compensation thin-film transistor, and a gate electrode of the third thin-film transistor T3 may be connected to the scan line SL. A source electrode (or a drain electrode) of the third thin-film transistor T3 may be connected to a drain electrode (or a source electrode) of the first thin-film transistor T1 and be connected to a first electrode of the light-emitting diode LED through the sixth thin-film transistor T6. A drain electrode (or a source electrode) of the third thin-film transistor T3 may be connected to one of electrodes of the storage capacitor Cst, a source electrode (or a drain electrode) of the fourth thin-film transistor T4, and a gate electrode of the first thin-film transistor T1. The third thin-film transistor T3 is turned on according to a scan signal Sn received through the scan line SL and diode-connect the first thin-film transistor T1 by connecting the gate electrode and the drain electrode (or source electrode) of the first thin-film transistor T1 to each other.

The fourth thin-film transistor T4 is an initialization thin-film transistor, and a gate electrode of the fourth thin-film transistor T4 may be connected to a previous scan line SL-1. A drain electrode (or source electrode) of the fourth thin-film transistor T4 may be connected to an initialization voltage line VL. A source electrode (or a drain electrode) of the fourth thin-film transistor T4 may be connected to one of the electrodes of the storage capacitor Cst, a drain electrode (or a source electrode) of the third thin-film transistor T3, and the gate electrode of the first thin-film transistor T1. The fourth thin-film transistor T4 may be turned on according to a previous scan signal Sn-1 received through the previous scan line SL-1 and may perform an initialization operation of initializing the voltage of the gate electrode of the first thin-film transistor T1 by transferring an initialization voltage Vint to the gate electrode of the first thin-film transistor T1.

The fifth thin-film transistor T5 is an operation control thin-film transistor, and a gate electrode of the fifth thin-film transistor T5 may be connected to an emission control line EL. A source electrode (or drain electrode) of the fifth thin-film transistor T5 may be connected to the driving voltage line PL. A drain electrode (or a source electrode) of the fifth thin-film transistor T5 is connected to the source electrode (or the drain electrode) of the first thin-film transistor T1 and a drain electrode (or a source electrode) of the second thin-film transistor T2.

The sixth thin-film transistor T6 is an emission control thin-film transistor, and a gate electrode of the sixth thin-film transistor T6 may be connected to the emission control line EL. A source electrode (or drain electrode) of the sixth thin-film transistor T6 is connected to the drain electrode (or source electrode) of the first thin-film transistor T1 and a source electrode (or drain electrode) of the third thin-film transistor T3. A drain electrode (or a source electrode) of the sixth thin-film transistor T6 may be electrically connected to the first electrode of the light-emitting diode LED. The fifth thin-film transistor T5 and the sixth thin-film transistor T6 may be simultaneously turned on according to an emission control signal En transferred through the emission control line EL, the first power voltage ELVDD is transferred to the light-emitting diode LED, and the driving current flows through the light-emitting diode LED.

The seventh thin-film transistor T7 may be an initialization thin-film transistor configured to initialize the first electrode of the light-emitting diode LED. A gate electrode of the seventh thin-film transistor T7 may be connected to a next scan line SL+1. A source electrode (or a drain electrode) of the seventh thin-film transistor T7 may be connected to the first electrode of the light-emitting diode LED. A drain electrode (or a source electrode) of the seventh thin-film transistor T7 may be connected to the initialization voltage line VL. The seventh thin-film transistor T7 may be turned on according to a next scan signal Sn+1 transferred through the next scan line SL+1 and may initialize the first electrode of the light-emitting diode LED.

Although it is shown in FIG. 9 that the fourth thin-film transistor T4 and the seventh thin-film transistor T7 are respectively connected to the previous scan line SL-1 and the next scan line SL+1, both the fourth thin-film transistor T4 and the seventh thin-film transistor T7 may be connected to the previous scan line SL-1 and driven according to a previous scan signal Sn-1 in an embodiment.

Another electrode of the storage capacitor Cst may be connected to the driving voltage line PL. One of the electrodes of the storage capacitor Cst may be connected to the gate electrode of the first thin-film transistor T1, the drain electrode (or source electrode) of the third thin-film transistor T3, and the source electrode (or drain electrode) of the fourth thin-film transistor T4 together.

A second electrode (e.g., a cathode) of the light-emitting diode LED is configured to receive the second power voltage ELVSS. The light-emitting diode LED is configured to emit light by receiving the driving current from the first thin-film transistor T1.

The light-emitting diode LED may be an organic light-emitting diode including an organic material as an emission material. In an embodiment, the light-emitting diode LED may be an inorganic light-emitting diode including an inorganic material. The inorganic light-emitting diode may include a PN-juction diode including inorganic material semiconductor-based materials. When a forward voltage is applied to a PN-junction diode, holes and electrons are injected, and light of a preset color may be emitted while energy created by recombination of the holes and the electrons is converted to light energy. The inorganic light-emitting diode may have a width of several micrometers to hundreds of micrometers, or several nanometers to hundreds of nanometers. In an embodiment, the light-emitting diode LED may include a light-emitting diode including quantum dots. As described above, the emission layer of the light-emitting diode LED may include an organic material, an inorganic material, quantum dots, an organic material and quantum dots, or an inorganic material and quantum dots. Hereinafter, for convenience of description, a case where the light-emitting diode LED is an organic light-emitting diode is described.

Although it is shown in FIG. 9 that the sub-pixel circuit PC includes seven thin-film transistors and one storage capacitor, the sub-pixel circuit PC may include two or more thin-film transistors and two or more capacitors in an embodiment. In addition, a circuit design of the sub-pixel circuit PC is not limited to the design shown in FIG. 9 and may be variously modified.

First to seventh thin-film transistors T1, T2, T3, T4, T5, T6, and T7 may be various types of thin-film transistors. In an embodiment, as shown in FIG. 9, all of the first to seventh thin-film transistors T1, T2, T3, T4, T5, T6, and T7 may be p-channel metal oxide semiconductor (MOS) field effect transistors (FET) (PMOSFETs). In an embodiment, at least one of the first to seventh thin-film transistors T1, T2, T3, T4, T5, T6, and T7 may be a PMOSFET, and the rest may be n-channel metal oxide semiconductor (MOS) field effect transistors (FET) (NMOSFETs). In an embodiment, all of the first to seventh thin-film transistors T1, T2, T3, T4, T5, T6, and T7 may be NMOSFETs. The positions of the source electrodes and the drain electrodes may be exchanged with each other depending on the type (a p-type or an n-type) of the transistor.

All of the first to seventh thin-film transistors T1, T2, T3, T4, T5, T6, and T7 shown in FIG. 9 may be thin-film transistors having a low temperature polycrystalline silicon (LTPS) semiconductor layer. In this case, the first to seventh thin-film transistors T1, T2, T3, T4, T5, T6, and T7 are not limited thereto and at least one of the first to seventh thin-film transistors T1, T2, T3, T4, T5, T6, and T7 may be a thin-film transistor having an LTPS semiconductor layer, and the rest may be thin-film transistors having an oxide semiconductor layer. Alternatively, all of the first to seventh thin-film transistors T1, T2, T3, T4, T5, T6, and T7 may be thin-film transistors having an oxide semiconductor layer.

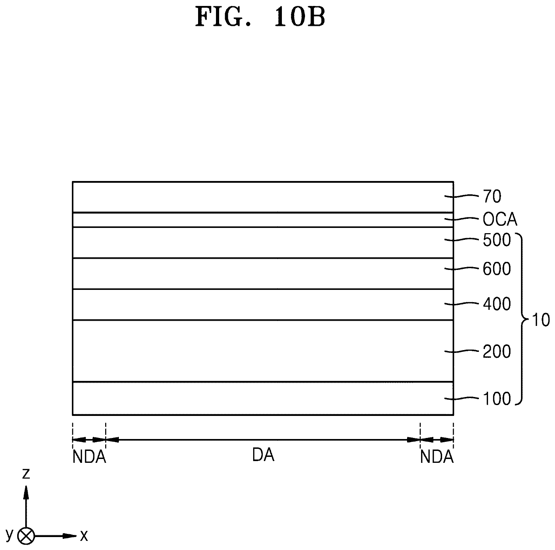

FIGS. 10A and 10B are schematic cross-sectional views of a portion of the display device DV shown in FIG. 6.

Referring to FIGS. 10A and 10B, the display device DV may include the display panel 10 including the substrate 100, a display layer 200, an encapsulation layer 400, a touch sensor layer 500, and an anti-reflection layer 600, an adhesive layer OCA, and the cover window 70.

The substrate 100 may include glass or polymer resin. As an example, the polymer resin may include polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 including the polymer resin may be flexible, rollable, or bendable. The substrate 100 may have a multi-layered structure including a layer which includes a polymer resin and an inorganic layer (not shown).

The display layer 200 may include a light-emitting diode as a light-emitting element, a thin-film transistor, and insulating layers variously therebetween, the thin-film transistor being electrically connected to the light-emitting diode, for example, an organic light-emitting diode.

Although not shown in the drawing, the display panel 10 may further include a low-reflective layer on the display layer 200, and the encapsulation layer 400 may be disposed on the low-reflective layer. As an example, the display layer 200 and/or the low-reflective layer may be sealed by the encapsulation layer 400. In an embodiment, the low-reflective layer may be omitted. In this case, the encapsulation layer 400 may be directly disposed on the display layer 200. The encapsulation layer 400 may include at least one inorganic encapsulation layer and at least one organic encapsulation layer.

In an embodiment, an encapsulation substrate (not shown) including glass may be provided instead of the encapsulation layer 400. The encapsulation substrate may be disposed on the display layer 200, and the display layer 200 may be disposed between the substrate 100 and the encapsulation substrate. There may be a gap between the encapsulation substrate and the display layer 200, and the gap may be filled with a filler.

The touch sensor layer 500 may be disposed on the encapsulation layer 400. The touch sensor layer 500 may sense an external input, for example, a touch of a finger or an object such as a stylus pen and allow the display device DV to obtain coordinate information corresponding to the touch position. The touch sensor layer 500 may include a touch electrode and trace lines which are connected to the touch electrode. The touch sensor layer 500 may sense an external input using a mutual capacitive method or a self-capacitive method.

The touch sensor layer 500 may be directly formed on the encapsulation layer 400. Alternatively, the touch sensor layer 500 may be formed separately, and then attached to the encapsulation layer 400 through an adhesive layer such as an optically clear adhesive.

The anti-reflection layer 600 may be disposed on the touch sensor layer 500. The anti-reflection layer 600 may reduce the reflectivity of external light incident toward the display device DV from the outside through the cover window 70.

The anti-reflection layer 600 may include a light-blocking layer and color filters. The color filters may be arranged by taking into account colors of lights emitted respectively from the light-emitting diodes of the display layer 200.

The cover window 70 may be disposed on the anti-reflection layer 600. The cover window 70 may protect layers covered by the cover window 70. The cover window 70 may be formed separately and attached to the anti-reflection layer 600 by the adhesive layer OCA disposed between the cover window 70 and the anti-reflection layer 600. The adhesive layer OCA may be, for example, an optically transparent adhesive. Alternatively, the cover window 70 may be directly disposed on the anti-reflection layer 600.

Referring to FIG. 10B, the touch sensor layer 500 may be disposed on the anti-reflection layer 600. In this case, the anti-reflection layer 600 may be disposed on the encapsulation layer 400, and the touch sensor layer 500, the adhesive layer OCA, and the cover window 70 may be sequentially disposed on the anti-reflection layer 600. However, for convenience of description, the case where the anti-reflection layer 600 is disposed on the touch sensor layer 500 is mainly described in detail.

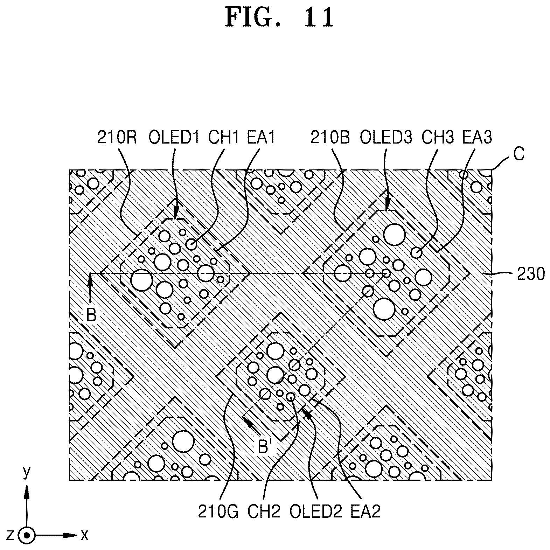

FIG. 11 is a schematic plan view of a portion of the display device DV disposed in a portion of the display area DA shown in FIG. 6. FIG. 11 is an enlarged view of region "C" shown in FIG. 8.

Referring to FIG. 11, the display area DA may include a plurality of sub-pixels including a plurality of display elements. More than one sub-pixel may be provided in a same one pixel, without being limited thereto. The plurality of display elements may include organic light-emitting diodes emitting light of different colors. As an example, the plurality of display elements may include a first organic light-emitting diode OLED1, a second organic light-emitting diode OLED2, and a third organic light-emitting diode OLED3.

The first organic light-emitting diode OLED1, the second organic light-emitting diode OLED2, and the third organic light-emitting diode OLED3 may share an opposite electrode 230. The opposite electrode 230 may be disposed on the entire surface of the display area DA shown in FIG. 8.

A first opening CH1 may be defined in a portion of the opposite electrode 230 disposed in a first emission area EA1, which is a region in which light emitted from the first organic light-emitting diode OLED1 is emitted. The first opening CH1 may be provided in plurality, and the plurality of first openings CH1 may be disposed spaced apart from each other. At a same one of the first emission area EA1, at least two of the plurality of first openings CH1 may be different from each other in their planar shape and/or size. The plurality of first openings CH1 may be disposed inside the first emission area EA1. That is, a planar area (or planar dimension) of the first opening CH1 may be smaller than or equal to a total planar area of the first emission area EA1. In addition, the plurality of first openings CH1 may be disposed inside the planar shape of a first sub-pixel electrode 210R of the first organic light-emitting diode OLED1. The planar shape of the first sub-pixel electrode 210R may be greater than the planar shape of the first emission area EA1.

A second opening CH2 may be disposed in a portion of the opposite electrode 230 disposed in a second emission area EA2, which is a region in which light emitted from the second organic light-emitting diode OLED2 is emitted. The second opening CH2 may be provided in plurality, and the plurality of second openings CH2 may be disposed spaced apart from each other. At a same one of the second emission area EA2, at least two of the plurality of second openings CH2 may be different from each other in their planar shape and/or size. The plurality of second openings CH2 may be disposed inside the second emission area EA2. In addition, the plurality of second openings CH2 may be disposed inside the planar shape of a second sub-pixel electrode 210G of the second organic light-emitting diode OLED2. The planar shape of the second sub-pixel electrode 210G may be greater than the planar shape of the second emission area EA2.

A third opening CH3 may be disposed in a portion of the opposite electrode 230 disposed in a third emission area EA3, which is a region in which light emitted from the third organic light-emitting diode OLED3 is emitted. The third opening CH3 may be provided in plurality, and the plurality of third openings CH3 may be disposed spaced apart from each other. At a same one of the third emission area EA3, at least two of the plurality of third openings CH3 may be different from each other in their planar shape and/or size. The plurality of third openings CH3 may be disposed inside the third emission area EA3. In addition, the plurality of third openings CH3 may be disposed inside the planar shape of a third sub-pixel electrode 210B of the third organic light-emitting diode OLED3. The planar shape of the third sub-pixel electrode 210B may be greater than the planar shape of the third emission area EA3.

The first to third openings CH1, CH2, and CH3 may be disposed to pass completely through the opposite electrode 230 in the thickness direction of the opposite electrode 230. The first to third openings CH1, CH2, and CH3 may respectively expose a first intermediate layer, a second intermediate layer, and a third intermediate layer to the outside of the opposite electrode 230.

The first to third openings CH1, CH2, and CH3 may be randomly formed in the opposite electrode 230 corresponding to the emission areas, respectively. The first to third openings CH1, CH2, and CH3 may have the planar shapes the same as or different from each other. In addition, the first to third openings CH1, CH2, and CH3 may be different from each other in size or planar dimension. Hereinafter, for convenience of description, a case where all of the planar shapes of the first to third openings CH1, CH2, and CH3 are circles is mainly described.

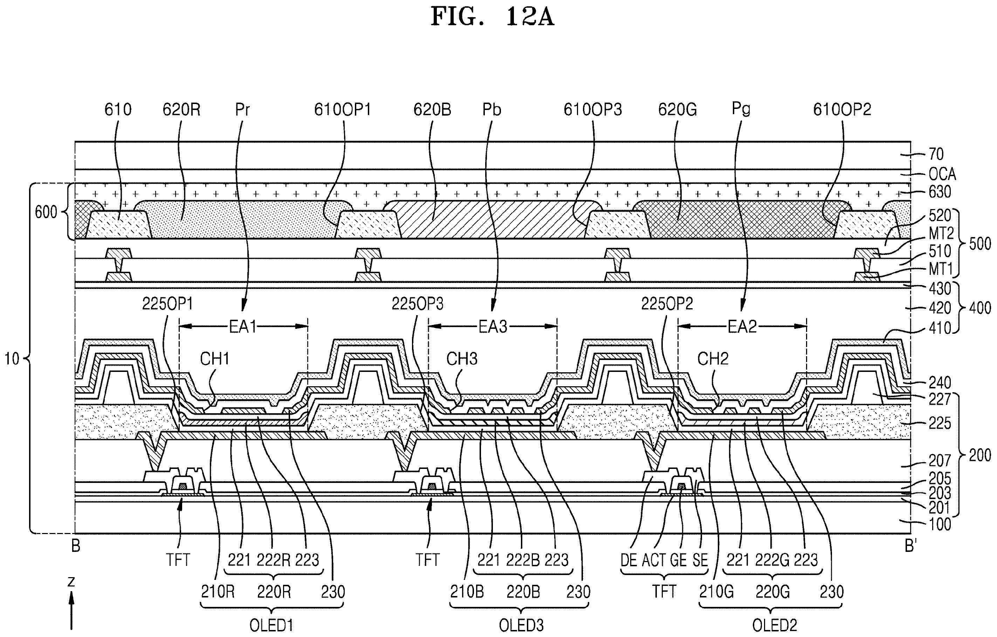

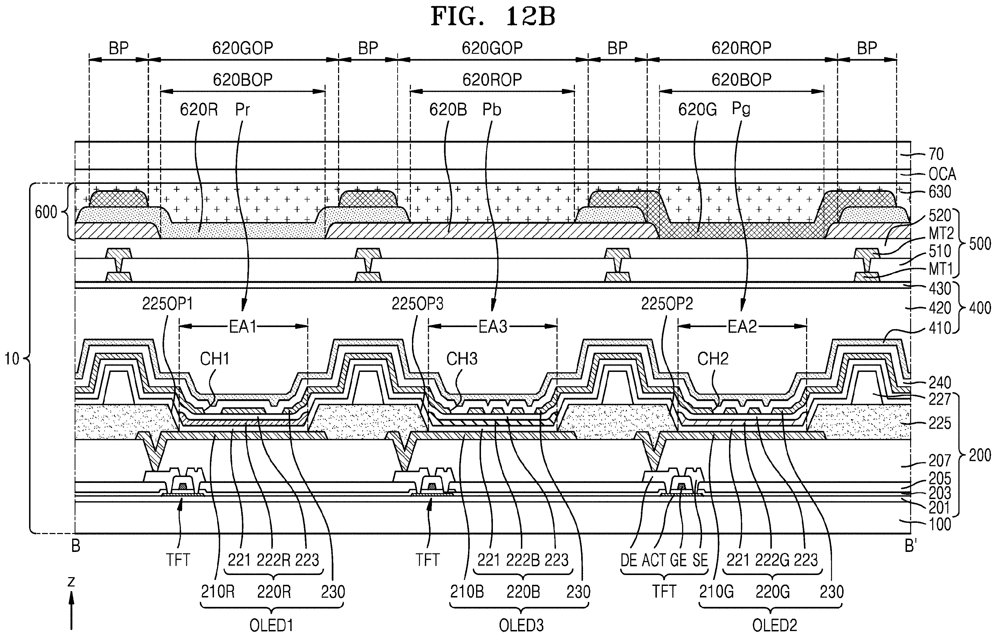

FIGS. 12A and 12B are cross-sectional views of the display device DV, taken along line B-B' of FIG. 11.

Referring to FIG. 12A, the display device DV may include the display panel 10 including the substrate 100, the display layer 200, the encapsulation layer 400, the touch sensor layer 500, and the anti-reflection layer 600, the adhesive layer OCA, and the cover window 70.

The display panel 10 may include a plurality of sub-pixels disposed in the display area DA (see FIG. 8). Each of the plurality of sub-pixels may be configured to emit red, green, or blue light. The plurality of sub-pixels may include sub-pixels configured to emit light of different colors from each other, for example, a first sub-pixel, a second sub-pixel, and a third sub-pixel. The first sub-pixel, the second sub-pixel, and the third sub-pixel may be provided in plurality. In an embodiment, the first sub-pixel may be a red sub-pixel Pr configured to emit red light, the second sub-pixel may be a green sub-pixel Pg configured to emit green light, and the third sub-pixel may be a blue sub-pixel Pb configured to emit blue light. One or more of the sub-pixels may be in a same pixel.

The display layer 200 may be disposed on the substrate 100. The display layer 200 may include a sub-pixel circuit layer as a circuit layer and a light-emitting diode layer as a light-emitting layer. The sub-pixel circuit layer may include a thin-film transistor TFT, a buffer layer 201, a gate insulating layer 203, an interlayer insulating layer 205, and a planarization layer 207, which are each insulating layers. One or more of these insulating layers may be referred to as "an insulating layer."

The buffer layer 201 may be disposed on the substrate 100, may reduce or block penetration of foreign materials, moisture, or external air from below the substrate 100, and provide a flat surface on the substrate 100. The buffer layer 201 may include an inorganic material, an organic material, or an organic/inorganic composite material, and include a single layer or a multi-layer including an inorganic material and an organic material, the inorganic material including oxide or nitride.

A barrier layer (not shown) may be further disposed between the substrate 100 and the buffer layer 201, the barrier layer blocking penetration of external air. As an example, the buffer layer 201 may include silicon oxide or silicon nitride.

The thin-film transistor TFT may be disposed on the buffer layer 201. The thin-film transistor TFT may include a semiconductor layer ACT as an active layer, and a gate electrode GE, a source electrode SE and a drain electrode DE as transistor electrodes. The thin-film transistor TFT may be connected to an organic light-emitting diode to drive the organic light-emitting diode.

The semiconductor layer ACT may be disposed on the buffer layer 201. The semiconductor layer ACT may include polycrystalline silicon or amorphous silicon. Alternatively, the semiconductor layer ACT may include an oxide of at least one of indium (In), gallium (Ga), tin (Sn), zirconium (Zr), vanadium (V), hafnium (Hf), cadmium (Cd), germanium (Ge), chromium (Cr), titanium (Ti), and zinc (Zn). The semiconductor layer ACT may include a channel region, a source region, and a drain region, the source region and the drain region being doped with impurities.

The gate electrode GE, the source electrode SE, and the drain electrode DE may include various conductive materials. In an embodiment, the gate electrode GE may include at least one of molybdenum (Mo), aluminum (Al), copper (Cu), and titanium (Ti). As an example, the gate electrode GE may be a single Mo layer or have a three-layered structure including a Mo layer, an Al layer, and a Mo layer. In an embodiment, the source electrode SE and the drain electrode DE may each include at least one of cupper (Cu), titanium (Ti), and aluminum (Al). As an example, the source electrode SE and the drain electrode DE may have a three-layered structure including a Ti layer, an Al layer, and a Ti layer.

To secure insulation between the semiconductor layer ACT and the gate electrode GE, the gate insulating layer 203 may be disposed between the semiconductor layer ACT and the gate electrode GE. The interlayer insulating layer 205 may be disposed on the gate electrode GE, and the source electrode SE and the drain electrode DE may be disposed on the interlayer insulating layer 205.

Each of the gate insulating layer 203 and the interlayer insulating layer 205 may include an inorganic material such as silicon oxide, silicon nitride, and/or silicon oxynitride. The gate insulating layer 203 and the interlayer insulating layer 205 may each be formed by, for example, chemical vapor deposition (CVD) or atomic layer deposition (ALD).

The planarization layer 207 may be disposed on the thin-film transistor TFT. To provide a flat upper surface, the planarization layer 207 is formed (or provided) and then chemical and mechanical polishing may be performed on the upper surface of the planarization layer 207. The planarization layer 207 may include a general-purpose polymer such as photosensitive polyimide, polyimide, polycarbonate, benzocyclobutene (BCB), hexamethyldisiloxane (HMDSO), polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, or a vinyl alcohol-based polymer.

Although it is shown in FIG. 12A that the planarization layer 207 is a single layer, the planarization layer 207 may include a multi-layer in an embodiment. The first to third sub-pixel electrodes 210R, 210G, and 210B of the first organic light-emitting diode OLED1, the second organic light-emitting diode OLED2, and the third organic light-emitting diode OLED3, which are a first display element, a second display element, and a third display element, respectively, may be electrically connected to the thin-film transistors TFT through contact holes in the planarization layer 207.

The light-emitting diode layer may be disposed on the sub-pixel circuit layer. In an embodiment, the light-emitting diode layer may include the first to third organic light-emitting diodes OLED1, OLED2, and OLED3, a bank layer 225, and a spacer 227 of a spacer layer. A bank of the display panel 10 may include not only a material of the bank layer 225 but also a material (e.g., solid portion) of the spacer 227. Here, an overall bank opening may be defined by an upper bank opening between inner sidewalls of the spacer 227 and a lower bank opening between inner sidewalls of the bank layer 225. The upper bank opening and the lower bank opening may overlap each other to define a bank opening of the display panel 10.

The first organic light-emitting diode OLED1, the second organic light-emitting diode OLED2, and the third organic light-emitting diode OLED3 may be disposed on the sub-pixel circuit layer. The first organic light-emitting diode OLED1 may include a first sub-pixel electrode 210R, a first intermediate layer 220R including a first common layer 221, a first emission layer 222R, and a second common layer 223, and an opposite electrode 230. The second organic light-emitting diode OLED2 may include a stack structure of a second sub-pixel electrode 210G, a second intermediate layer 220G including the first common layer 221, a second emission layer 222G, and the second common layer 223, and the opposite electrode 230. The third organic light-emitting diode OLED3 may include a third sub-pixel electrode 210B, a third intermediate layer 220B including the first common layer 221, a third emission layer 222B, and the second common layer 223, and the opposite electrode 230. The first opening CH1 may be defined in the opposite electrode 230, at in the first emission area EA1. In addition, the second opening CH2 may be defined in the opposite electrode 230, at the second emission area EA2, and the third opening CH3 may be defined in the opposite electrode 230, at the third emission area EA3.

The first to third sub-pixel electrodes 210R, 210G, and 210B may each be disposed on the planarization layer 207. The first to third sub-pixel electrodes 210R, 210G, and 210B may be disposed spaced apart from each other. The first to third sub-pixel electrodes 210R, 210G, and 210B may be in a same layer as each other. As being in a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

The first to third sub-pixel electrode 210R, 210G, and 210B may be reflective electrodes. The first to third sub-pixel electrodes 210R, 210G, and 210B may include a reflective layer and a transparent or semi-transparent conductive layer on the reflective layer, the reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. The transparent or semi-transparent conductive layer may include at least one of indium tin oxide (ITO), indium zinc oxide (IZO), zinc oxide (ZnO), indium oxide (In₂O₃), indium gallium oxide (IGO), and aluminum zinc oxide (AZO).

The bank layer 225 may be disposed on the first to third sub-pixel electrodes 210R, 210G, and 210B. The bank layer 225 may overlap the first to third sub-pixel electrodes 210R, 210G, and 210B and include first to third lower openings 225OP1, 225OP2, and 225OP3 defined therein and respectively exposing the central portions of the first to third sub-pixel electrodes 210R, 210G, and 210B. The solid portion of the bank layer 225 may cover the edges of the first to third sub-pixel electrodes 210R, 210G, and 210B and prevent (electrical) arc and the like from occurring at the edges of the first to third sub-pixel electrodes 210R, 210G, and 210B by increasing a distance between the edges of the first to third sub-pixel electrodes 210R, 210G, and 210B and the opposite electrode 230. The first to third lower openings 225OP1, 225OP2, and 225OP3 as a bank opening provided in plural (e.g., bank openings), may be defined in the material of the bank layer 225.

The first to third lower openings 225OP1, 225OP2, and 225OP3 of the bank layer 225 may define the first to third emission areas EA1, EA2, and EA3 of the first to third organic light-emitting diodes OLED1, OLED2, and OLED3 respectively included in the sub-pixels. As shown in FIG. 12A, the bank layer 225 may include the first lower opening 225OP1 which defines the first emission area EA1 of the first organic light-emitting diode OLED1 of the first sub-pixel. In addition, the bank layer 225 may include the second lower opening 225OP2 which defines the second emission area EA2 of the second organic light-emitting diode OLED2 of the second sub-pixel, and the bank layer 225 may include the third lower opening 225OP3 which defines the third emission area EA3 of the third organic light-emitting diode OLED3 of the third sub-pixel.

The bank layer 225 may include an organic insulating material. Alternatively, the bank layer 225 may include an inorganic insulating material such as silicon nitride or silicon oxide. In an embodiment, the bank layer 225 may include an organic insulating material and an inorganic insulating material.

In an embodiment, the bank layer 225 may include a light-blocking material. As an example, the light-blocking material of the bank layer 225 may be black. The light-blocking material may include carbon black, carbon nanotubes, a resin or paste including black dye, metal (for example, nickel, aluminum, molybdenum, and an alloy thereof) particles, metal oxide particles or metal nitride particles. In the case where the bank layer 225 includes a light-blocking material, external light reflection by metal structures arranged below the bank layer 225 may be reduced.

The spacer 227 may be disposed on the bank layer 225. The spacer 227 may include an organic insulating material such as polyimide. Alternatively, the spacer 227 may include an inorganic insulating material such as silicon nitride or silicon oxide, or include an organic insulating material and an inorganic insulating material. In an embodiment, the spacer 227 may include a material different from that of the bank layer 225 including the light-blocking material. The spacer 227 and the bank layer 225 may be respectively formed in separate processes.

In an embodiment, the spacer 227 may include the same material as a material of the bank layer 225. In this case, the bank layer 225 and the spacer 227 may be simultaneously formed during a mask process which uses a half-tone mask.

The intermediate layer may be disposed on the first to third sub-pixel electrodes 210R, 210G, and 210B and the bank layer 225. As described above, the intermediate layer may include the first common layer 221, the emission layer, and the second common layer 223.

The first to third emission layers 222R, 222G, and 222B may be disposed as patterns inside the first to third lower openings 225OP1, 225OP2, and 225OP3 of the bank layer 225. The first to third emission layers 222R, 222G, and 222B may include an organic material including a fluorescent or phosphorous material which may emit green, blue, or red light. The organic material may include a low molecular weight organic material or a polymer organic material.

The first common layer 221 and the second common layer 223 may be respectively disposed under and on the emission layer. The first common layer 221 may include, for example, a hole transport layer (HTL), or include an HTL and a hole injection layer (HIL). The second common layer 223 may include, for example, an electron transport layer (ETL), or include an ETL and an electron injection layer (EIL). In an embodiment, the second common layer 223 need not be provided.

The emission layer is arranged for each sub-pixel to correspond to the first to third lower openings 225OP1, 225OP2, and 225OP3 of the bank layer 225. In contrast, the first common layer 221 and the second common layer 223 may each be integrally formed to cover the substrate 100 entirely. In other words, the first common layer 221 and the second common layer 223 may each be integrally formed to cover the display area DA of the substrate 100 entirely.

The opposite electrode 230 may be a cathode which is an electron injection electrode. The opposite electrode 230 may include a conductive material having a low work function. As an example, the opposite electrode 230 may include a (semi) transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the opposite electrode 230 may further include a layer on the (semi) transparent layer, the layer including ITO, IZO, ZnO, or In₂O₃.

In an embodiment, a capping layer 240 may be further disposed on the display layer 200. The capping layer 240 may be disposed on the first to third organic light-emitting diodes OLED1, OLED2, and OLED3. In an embodiment, the capping layer 240 may improve a light-emission efficiency of the first to third organic light-emitting diodes OLED1, OLED2, and OLED3 due to a principle of constructive interference.

The capping layer 240 may be an organic capping layer including an organic material, an inorganic capping layer including an inorganic material, or a composite capping layer including an organic material and an inorganic material. As an example, the capping layer 240 may include a carbocyclic compound, a heterocyclic compound, an amine group-containing compound, porphine derivatives, phthalocyanine derivatives, naphthalocyanine derivatives, alkali metal complexes, alkali earth metal complexes, or an arbitrary combination thereof. The carbocyclic compound, heterocyclic compound and amine group-containing compound may be optionally substituted with substituents including O, N, S, Se, Si, F, Cl, Br, I, or any combination thereof.

At least a portion of the capping layer 240 may be extended into the first opening CH1, the second opening CH2, and/or the third opening CH3. An extended portion of the capping layer 240 which is in a respective opening may fill the respective opening.

The encapsulation layer 400 may be disposed on the capping layer 240. The encapsulation layer 400 may include at least one inorganic encapsulation layer and at least one organic encapsulation layer. As an example, as shown in FIG. 12A, the encapsulation layer 400 may include a first inorganic encapsulation layer 410, an organic encapsulation layer 420, and a second inorganic encapsulation layer 430 which are sequentially stacked.

The first inorganic encapsulation layer 410 and the second inorganic encapsulation layer 430 may include an inorganic insulating material such as silicon oxide, silicon nitride, silicon oxynitride, aluminum oxide, titanium oxide, tantalum oxide, hafnium oxide, or zinc oxide. The first and second inorganic encapsulation layers 410 and 430 may include a single-layered structure or a multi-layered structure including the above inorganic insulating materials.

The organic encapsulation layer 420 may alleviate inner stress of the first inorganic encapsulation layer 410 and/or the second inorganic encapsulation layer 430. The organic encapsulation layer 420 may include a polymer-based material. As an example, the organic encapsulation layer 420 may include polyethylene terephthalate, polyethylene naphthalate, polycarbonate, polyimide, polyethylene sulfonate, polyoxymethylene, polyarylate, hexamethyldisiloxane, an acryl-based resin (e.g., polymethylmethacrylate, poly acrylic acid, etc.), or an arbitrary combination thereof.

The encapsulation layer 400 may have a multi-layered structure of the first inorganic encapsulation layer 410, the organic encapsulation layer 420, and the second inorganic encapsulation layer 430. In this case, even though cracks occur in the encapsulation layer 400, the cracks may not propagate between the first inorganic encapsulation layer 410 and the organic encapsulation layer 420, or between the organic encapsulation layer 420 and the second inorganic encapsulation layer 430. The encapsulation layer 400 may prevent or reduce external moisture, oxygen, or the like penetrating to the display area DA.

In an embodiment, at least one layer among the layers of the encapsulation layer 400 may extend into a bank opening overlapping the first opening CH1, the second opening CH2, and/or the third opening CH3. As an example, the first inorganic encapsulation layer 410, or the first inorganic encapsulation layer 410 and the organic encapsulation layer 420 together, may be disposed inside the bank opening corresponding to the first opening CH1, the second opening CH2, and/or the third opening CH3. Here, the overall bank opening may include overlapping openings of the bank layer 225 and the spacer layer (e.g., between spacers 227).

The touch sensor layer 500 may be disposed on the encapsulation layer 400. The touch sensor layer 500 may include a first touch electrode MT1, a first touch insulating layer 510, a second touch electrode MT2, and a second touch insulating layer 520. The first touch electrode MT1 may be directly disposed on the encapsulation layer 400. As an example, the first touch electrode MT1 may be directly disposed on the second inorganic encapsulation layer 430 of the encapsulation layer 400. However, the disclosure is not limited thereto.

In an embodiment, the touch sensor layer 500 may include an insulating layer (not shown) between the first touch electrode MT1 and the encapsulation layer 400. In this case, the insulating layer may be disposed on the second inorganic encapsulation layer 430 of the encapsulation layer 400 to planarize a surface on which the first touch electrode MT1 and the like is disposed. The insulating layer may include an inorganic insulating material such as silicon oxide, silicon nitride, and silicon oxynitride. In an embodiment, the insulating layer may include an organic insulating material.

The first touch insulating layer 510 may be disposed on the first touch electrode MT1. The first touch insulating layer 510 may include an inorganic material or an organic material. In the case where the first touch insulating layer 510 includes an inorganic material, the first touch insulating layer 510 may include at least one among silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. In the case where the first touch insulating layer 510 includes an organic material, the first touch insulating layer 510 may include at least one material among acrylic resin, methacrylic resin, polyisoprene, vinyl resin, epoxy resin, urethane resin, cellulose resin, and perylene resin.

The second touch electrode MT2 may be disposed on the first touch insulating layer 510. The second touch electrode MT2 may serve as a sensor which senses a user's touch input. The first touch electrode MT1 may serve as a connector which connects the second touch electrode MT2 patterned in one direction. In an embodiment, both the first touch electrode MT1 and the second touch electrode MT2 may serve as sensors. In this case, the first touch electrode MT1 may be electrically connected to the second touch electrode MT2 through a contact hole. In the case where both the first touch electrode MT1 and the second touch electrode MT2 may serve as sensors, a resistance of a touch electrode is reduced and a user's touch input may be swiftly sensed.

In an embodiment, the first touch electrode MT1 and the second touch electrode MT2 may have a structure through which light emitted from the organic light-emitting diode passes, for example, a mesh structure. In this case, a material (e.g., a solid portion of) the first touch electrode MT1 and the second touch electrode MT2 need not overlap each emission area of the organic light-emitting diode. Where the material of the touch electrodes are spaced apart from each other with a gap (or opening) therebetween to define the mesh structure of a touch electrode layer, light emitting from a light-emitting element may pass through the touch electrode layer.

The first touch electrode MT1 and the second touch electrode MT2 may each include a metal layer or a transparent conductive layer. The metal layer may include at least one of molybdenum (Mo), silver (Ag), titanium (Ti), copper (Cu), aluminum (Al), and an alloy thereof. The transparent conductive layer may include a transparent conductive oxide such as indium tin oxide (ITO), zinc oxide (ZnO), and indium tin zinc oxide (ITZO), a conductive polymer such as poly(3,4-ethylenedioxythiophene) (PEDOT), a metal nanowire, a carbon nanotube, or graphene.

The second touch insulating layer 520 may be disposed on the second touch electrode MT2. The second touch insulating layer 520 may include an inorganic material or an organic material. In the case where the second touch insulating layer 520 includes an inorganic material, the second touch insulating layer 520 may include at least one among silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. In the case where the second touch insulating layer 520 includes an organic material, the second touch insulating layer 520 may include at least one material among acrylic resin, methacrylic resin, polyisoprene, vinyl resin, epoxy resin, urethane resin, cellulose resin, and perylene resin.

In an embodiment, the touch sensor layer 500 may include the first touch electrode MT1, the first touch insulating layer 510, and the second touch electrode MT2, and need not include the second touch insulating layer 520. In this case, the anti-reflection layer 600 may have a structure which covers the second touch electrode MT2.

The anti-reflection layer 600 may be disposed on the touch sensor layer 500.

The anti-reflection layer 600 may include a light-blocking layer 610 and a plurality of color filters. In an embodiment, the anti-reflection layer 600 includes first to third color filters 620R, 620G, and 620B of different colors respectively corresponding to the first to third organic light-emitting diodes OLED1, OLED2, and OLED3. Each of the first to third color filters 620R, 620G, and 620B may be provided in plurality.

The light-blocking layer 610 may have first to third upper openings 610OP1, 610OP2, and 610OP3 respectively corresponding to the first to third sub-pixels. The light-blocking layer 610 may include the first upper opening 610OP1 corresponding to the first emission area EA1, the second upper opening 610OP2 corresponding to the second emission area EA2, and the third upper opening 610OP3 corresponding to the third emission area EA3. Light emitted from the first to third organic light-emitting diodes OLED1, OLED2, and OLED3 may be emitted to the outside of the display panel 10 (or the display device DV) through the first to third upper openings 610OP1, 610OP2, and 610OP3 of the light-blocking layer 610.

The first upper opening 610OP1 of the light-blocking layer 610 may overlap the first lower opening 225OP1 of the bank layer 225, the second upper opening 610OP2 may overlap the second lower opening 225OP2, and the third upper opening 610OP3 may overlap the third lower opening 225OP3.

In the present specification, the width (or the size) of each sub-pixel denotes the width (or the size) of the emission area of the organic light-emitting diode which implements each sub-pixel, and the width (or the size) of the emission area may be defined by the width (or the size) of the lower opening of the bank layer 225. As used herein, the width may be taken along a planar direction, such as along the xy-plane.

In an embodiment, the width (or the size) of each of the first to third upper openings 610OP1, 610OP2, and 610OP3 of the light-blocking layer 610 may be greater than the width (or the size) of the corresponding sub-pixel among the first to third sub-pixels. That is, the widths (or the sizes) of the first to third upper openings 610OP1, 610OP2, and 610OP3 of the light-blocking layer 610 may be respectively greater than the widths (or the sizes) of the corresponding first to third lower openings 225OP1, 225OP2, and 225OP3 of the bank layer 225.

In an embodiment, the width (or the size) of each of the first to third upper openings 610OP1, 610OP2, and 610OP3 of the light-blocking layer 610 may be substantially the same as the width (or the size) of the corresponding sub-pixel among the first to third sub-pixels. That is, the widths (or the sizes) of the first to third upper openings 610OP1, 610OP2, and 610OP3 of the light-blocking layer 610 may be respectively substantially the same as the widths (or the sizes) of the corresponding first to third lower openings 225OP1, 225OP2, and 225OP3 of the bank layer 225.

The light-blocking layer 610 may include an organic insulating material. Alternatively, the light-blocking layer 610 may include an inorganic insulating material such as silicon nitride or silicon oxide. In an embodiment, the light-blocking layer 610 may include an organic insulating material and an inorganic insulating material.

In an embodiment, the light-blocking layer 610 may include a light-blocking material. As an example, the light-blocking material of the light-blocking layer 610 may be black. The light-blocking material may include carbon black, carbon nanotubes, a resin or paste including black dye, metal(for example, nickel, aluminum, molybdenum, and an alloy thereof) particles, metal oxide particles or metal nitride particles. Since the light-blocking layer 610 includes the light-blocking material, external light reflection by metal structures disposed below the light-blocking layer 610 may be reduced.

The first to third color filters 620R, 620G, and 620B may be respectively arranged in the first to third upper openings 610OP1, 610OP2, and 610OP3 of the light-blocking layer 610. The first to third color filters 620R, 620G, and 620B may have colors corresponding to lights emitted from first to third emission areas EA1, EA2, and EA3. **In** an embodiment, in the case where the first emission area EA1 emits red light, the first color filter 620R may be a red color filter, in the case where the second emission area EA2 emits green light, the second color filter 620G may be a green color filter, and in the case where the third emission area EA3 emits blue light, the third color filter 620B may be a blue color filter.

The anti-reflection layer 600 may further include an overcoat layer 630. The overcoat layer 630 may be disposed on the light-blocking layer 610 and/or the first to third color filters 620R, 620G, and 630B. The overcoat layer 630 may planarize the upper surface of the light-blocking layer 610 and/or the first to third color filters 620R, 620G, and 630B. The overcoat layer 630 is a colorless light-transmissive layer which does not have a color in the visible light band. The overcoat layer 630 may include a colorless light-transmissive organic material such as an acryl-based resin.

The cover window 70 may be disposed over the overcoat layer 630 with the adhesive layer OCA therebetween.

FIG. 12B is a cross-sectional view of the display device DV, taken along line B-B' of FIG. 11. FIG. 12B shows a modified embodiment of the anti-reflection layer 600 of FIG. 12A. Hereinafter, differences are mainly described.

Referring to FIG. 12B, the anti-reflection layer 600 may include only the plurality of color filters without the light-blocking layer 610 (see FIG. 12A).

In an embodiment, the third color filter 620B, the first color filter 620R, and the second color filter 620G may be sequentially stacked in a direction (a +z direction) away from the substrate 100.

The third color filter 620B may be configured to pass most of blue light and block most of red light or green light. The third color filter 620B may include third openings 620BOP corresponding to the second emission area EA2 and the first emission area EA1. The third color filter 620B may include the third openings 620BOP such that green light and red light respectively emitted from the second emission area EA2 and the first emission area EA1 are not blocked. Most of blue light emitted from the third emission area EA3 may pass through the third color filter 620B and be emitted to the outside.

The first color filter 620R may be configured to pass most of red light and block most of blue light or green light. The first color filter 620R may fill some of the third openings 620BOP of the third color filter 620B corresponding to the first emission area EA1, and be disposed on the third color filter 620B. The first color filter 620R may include first openings 620ROP corresponding to the second emission area EA2 and the third emission area EA3. The first color filter 620R may include the first openings 620ROP such that green light and blue light respectively emitted from the second emission area EA2 and the third emission area EA3 are not blocked. Most of red light emitted from the first emission area EA1 may pass through the first color filter 620R and be emitted to the outside.

The second color filter 620G may be configured to pass most of green light and block most of red light or blue light. The second color filter 620G may fill some of the third openings 620BOP of the third color filter 620B and some of the first openings 620ROP of the first color filter 620R corresponding to the second emission area EA2, and be disposed on the first color filter 620R. The second color filter 620G may include second openings 620GOP corresponding to the first emission area EA1 and the third emission area EA3. The second color filter 620G may include the second openings 620GOP such that red light and blue light respectively emitted from the first emission area EA1 and the third emission area EA3 are not blocked. Most of green light emitted from the second emission area EA2 may pass through the second color filter 620G and be emitted to the outside.

The anti-reflection layer 600 may have light-blocking portions BP in a portion corresponding to a space between the first to third emission areas EA1, EA2, and EA3, or a space between the sub-pixel electrodes 210R, 210G, and 210B. Here, the light-blocking portions BP include the first to third color filters 620R, 620G, and 620B which are stacked to overlap each other. The light-blocking portions BP may be configured to block light even without the light-blocking layer 610 (see FIG. 12A) including a black light-blocking material. In addition, external light reflection of the display device DV may be reduced.

In an embodiment, the width (the size) of the first opening 620ROP of the first color filter 620R overlapping the second emission area EA2 of the second sub-pixel may be greater than the width (the size) of the third opening 620BOP of the third color filter 620B. The width (the size) of the second opening 620GOP of the second color filter 620G overlapping the third emission area EA3 of the third sub-pixel may be greater than the width (the size) of the first opening 620ROP of the first color filter 620R. The width (the size) of the second opening 620GOP of the second color filter 620G overlapping the first emission area EA1 of the first sub-pixel may be greater than the width (the size) of the third opening 620BOP of the third color filter 620B.

Among the openings at the various sub-pixels, a light emission area of a sub-pixel may be defined by an opening of the anti-reflection layer 600 (or the emission area), while a non-emission area between the light emission areas may be defined by material of the anti-reflection layer 600. In FIG. 12A, the non-emission area may be defined by a planar area of the light-blocking layer 610, such as a maximum width thereof. In FIG. 12B, the non-emission area may be defined by a planar area of the light-blocking portion BP which is common to each of the overlapping color filter portions.

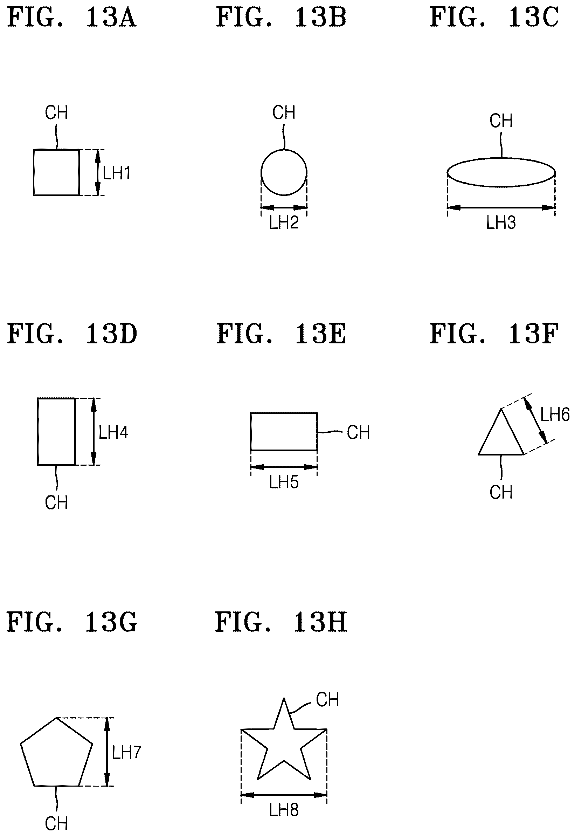

FIGS. 13A to 13H are schematic plan views of embodiments of the opening shown in FIG. 11.

Referring to FIGS. 13A to 13H, an opening CH, which is one of the first opening, the second opening, and the third opening defined in the opposite electrode 230, may have a planar shape of various types. Where multiple openings CH are defined in a same emission area, such openings may be referred to as sub-openings.

As an example, the planar shape of the opening CH as a sub-opening in a same emission area, may be a polygonal shape, a circular shape, and/or an elliptical shape. In an embodiment, the opening CH may have an irregular shape other than be a polygonal shape, a circular shape, and/ an elliptical shape. As an example, the opening CH may have a star-shaped planar shape as shown in FIG. 13H.

The maximum inner width of the opening CH is in a range of about 1 micrometer (µm) to about 10 micrometers (µm). As an example, in the case where the planar shape of the opening CH is a square (FIG. 13A), a first length LH1 of one side of the opening CH may be in a range of about 1 µm to about 10 µm.

In the case where the planar shape of the opening CH is a circular shape (FIG. 13B), a diameter LH2 of the opening CH may be in a range of about 1 µm to about 10 µm. In the case where the planar shape of the opening CH is an elliptical shape (FIG. 13C), a second length LH3 of a major axis of the opening CH may be in a range of about 1 µm to about 10 µm.

In the case where the planar shape of the opening CH is a rectangle (FIGS. 13D and 13E), a third length LH4 and LH5 of a long side of the opening CH may be in a range of about 1 µm to about 10 µm regardless of an extension direction of the long side of the rectangle.

In the case where the planar shape of the opening CH is a triangle (FIG. 13F), a fourth length LH6 of a largest side among three sides of the triangle may be in a range of about 1 µm to about 10 µm.

In the case where the planar shape of the opening CH is a pentagon (FIG. 13G), a fifth length LH7 having a maximum length in the inside of the pentagon may be in a range of about 1 µm to about 10 µm.

In the case where the planar shape of the opening CH is an irregular shape such as a star shape (FIG. 13H), a sixth length LH8 having a maximum length in the inside of the planar shape of the opening CH may be in a range of about 1 µm to about 10 µm.

In the case where a length of a maximum width in the planar shape of the opening CH is less than 1 µm, since external light may not be reflected in various directions through the opening CH, a reflection color band due to external light reflection may not be reduced. In the case where a length of a maximum width in the planar shape of the opening CH exceeds 10 µm, since a preset voltage may be applied to each intermediate layer, the brightness of each organic light-emitting diode may be reduced.

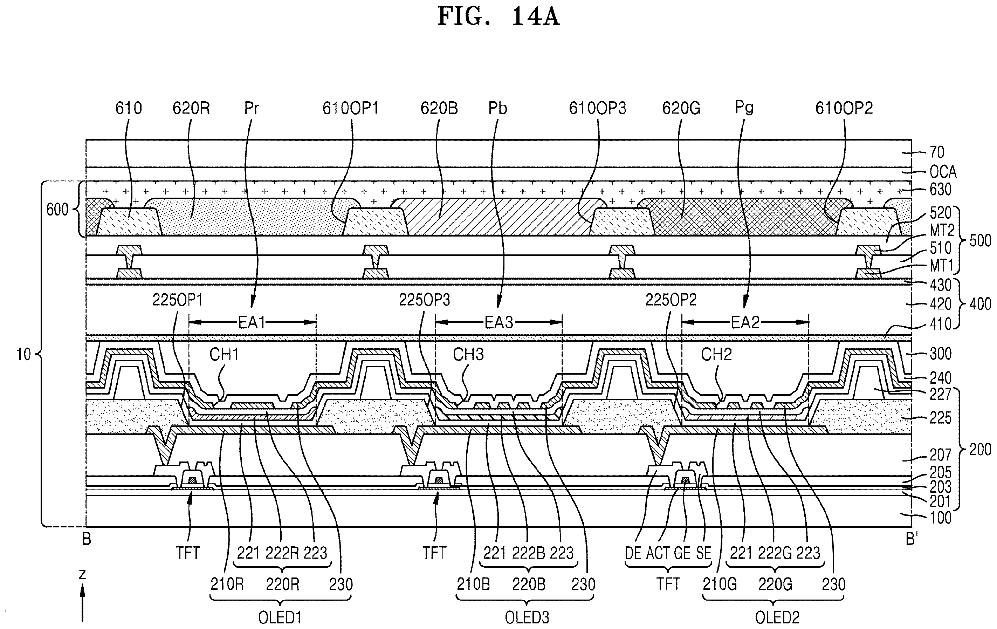

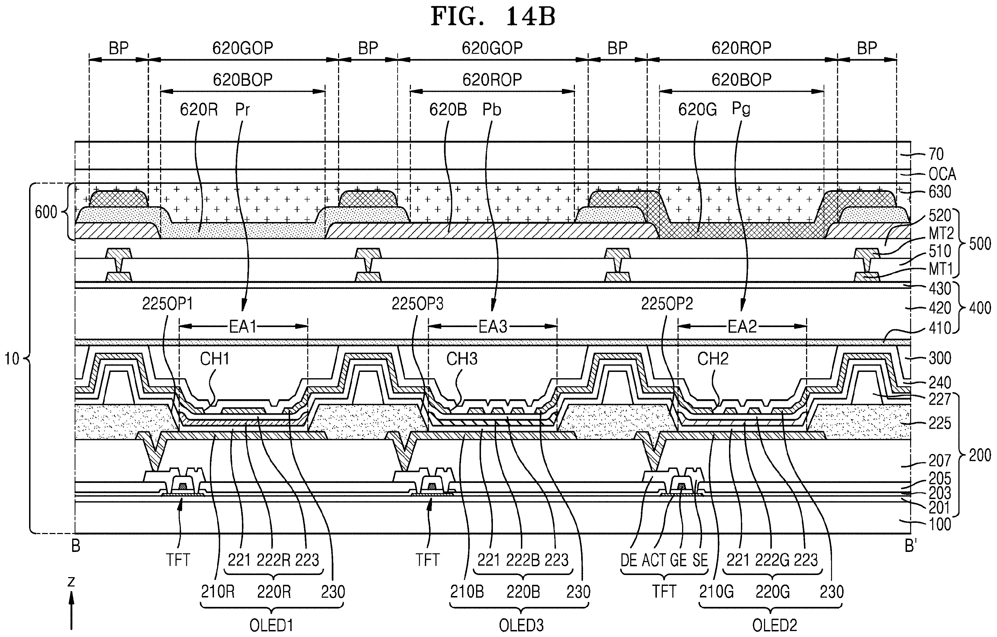

FIGS. 14A and 14B are schematic cross-sectional views of a portion of the display device DV according to an embodiment. Hereinafter, the same reference numerals as those of FIGS. 12A and 12B denote the same elements. Hereinafter, differences from FIGS. 12A and 12B are mainly described in detail.

Referring to FIGS. 14A and 14B, the display device DV may include the display panel 10 including the substrate 100, the display layer 200, the encapsulation layer 400, the touch sensor layer 500, and the anti-reflection layer 600, the adhesive layer OCA, and the cover window 70.

The display layer 200 may be disposed on the substrate 100. The display layer 200 may include the sub-pixel circuit layer and the light-emitting diode layer. The sub-pixel circuit layer may include thin-film transistors TFT, the buffer layer 201, the gate insulating layer 203, the interlayer insulating layer 205, and the planarization layer 207 as a lower planarization layer, which are insulating layers. The light-emitting diode layer may be disposed on the sub-pixel circuit layer. In an embodiment, the light-emitting diode layer may include the first to third organic light-emitting diodes OLED1, OLED2, and OLED3, the bank layer 225, and the spacer 227. The first organic light-emitting diode OLED1 may include the first sub-pixel electrode 210R, the first intermediate layer 220R including the first common layer 221, the first emission layer 222R, and the second common layer 223, and the opposite electrode 230, the second organic light-emitting diode OLED2 may include a stack structure of the second sub-pixel electrode 210G, the second intermediate layer 220G including the first common layer 221, the second emission layer 222G, and the second common layer 223, and the opposite electrode 230, and the third organic light-emitting diode OLED3 may include the third sub-pixel electrode 210B, the third intermediate layer 220B including the first common layer 221, the third emission layer 222B, and the second common layer 223, and the opposite electrode 230.

The first opening CH1 may be disposed in the opposite electrode 230 disposed in the first emission area EA1. In addition, the second opening CH2 may be disposed in the opposite electrode 230 disposed in the second emission area EA2, and the third opening CH3 may be disposed in the opposite electrode 230 disposed in the third emission area EA3.

The capping layer 240 may be disposed on the light-emitting diode layer. At least a portion of the capping layer 240 may be disposed inside the first to third openings CH1, CH2, and CH3.

An upper planarization layer 300 may be disposed on the capping layer 240. The upper planarization layer 300 may be disposed inside a bank opening including the first to third lower openings 225OP1, 225OP2, and 225OP3 of the bank layer 225 forming a lower opening portion of the bank opening. The upper planarization layer 300 disposed inside the bank opening corresponding to each of the first to third lower openings 225OP1, 225OP2, and 225OP3 may be disposed apart from each other in island shapes, such as to be disconnected from each other. The upper planarization layer 300 may include a material equal or similar to that of the organic encapsulation layer 420. At least a portion of the upper planarization layer 300 may be disposed inside the first to third openings CH1, CH2, and CH3.

The encapsulation layer 400 including the first inorganic encapsulation layer 410, the organic encapsulation layer 420, and the second inorganic encapsulation layer 430 may be disposed on the upper planarization layer 300 and the capping layer 240. The upper planarization layer 300 may reduce bending of the first inorganic encapsulation layer 410 by approximately planarizing a surface on which the first inorganic encapsulation layer 410 is disposed.

The touch sensor layer 500 including the first touch electrode MT1, the first touch insulating layer 510, the second touch electrode MT2, and the second touch insulating layer 520 may be disposed on the encapsulation layer 400.

As shown in FIG. 14A, the anti-reflection layer 600 including the first to third color filters 620R, 620G, and 620B of different colors respectively corresponding to the first to third organic light-emitting diodes OLED1, OLED2, and OLED3, and the light-blocking layer 610 of the non-emission area, may be disposed on the touch sensor layer 500. In an embodiment, the anti-reflection layer 600 including only the first to third color filters 620R, 620G, and 620B in the non-emission area without the light-blocking layer 610 may be disposed on the touch sensor layer 500 as shown in FIG. 14B. In this case, the anti-reflection layer 600 may include the light-blocking portion BP in the non-emission area including the first to third color filters 620R, 620G, and 620B which are stacked and overlapping each other to provide a light-blocking function.

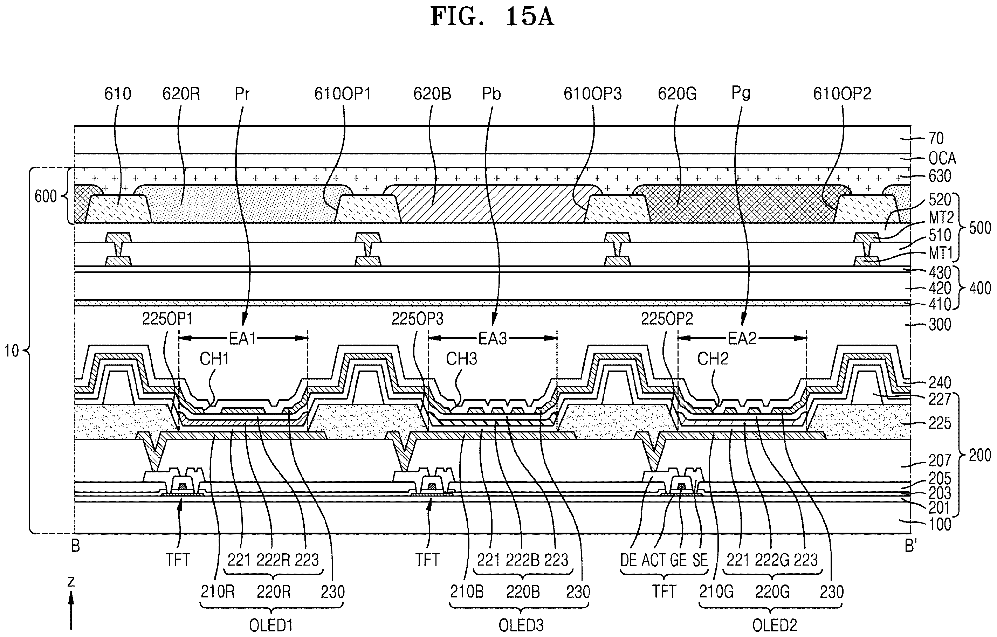

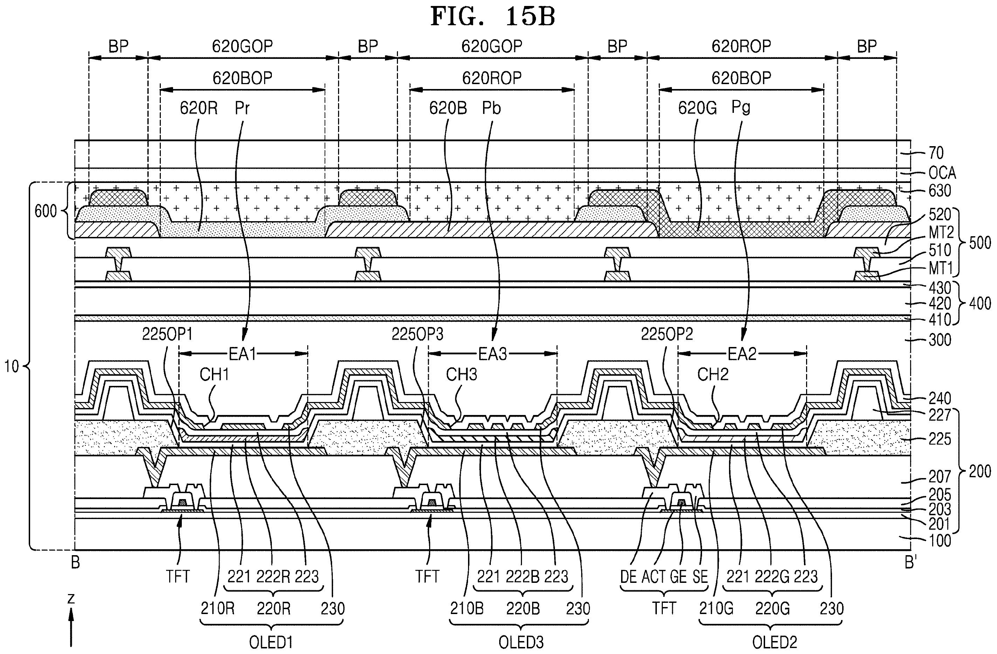

FIGS. 15A and 15B are schematic cross-sectional views of a portion of the display device DV according to an embodiment. Hereinafter, the same reference numerals as those of FIGS. 12A and 12B denote the same elements. Hereinafter, differences from FIGS. 12A and 12B are mainly described in detail.

Referring to FIGS. 15A and 15B, the display device DV may include the display panel 10 including the substrate 100, the display layer 200, the encapsulation layer 400, the touch sensor layer 500, and the anti-reflection layer 600, the adhesive layer OCA, and the cover window 70.

The display layer 200 may be disposed on the substrate 100. The display layer 200 may include the sub-pixel circuit layer and the light-emitting diode layer. The sub-pixel circuit layer may include the thin-film transistor TFT, the buffer layer 201, the gate insulating layer 203, the interlayer insulating layer 205, and the planarization layer 207, which are insulating layers. The light-emitting diode layer may be disposed on the sub-pixel circuit layer. In an embodiment, the light-emitting diode layer may include the first to third organic light-emitting diodes OLED1, OLED2, and OLED3, the bank layer 225, and the spacer 227. The first organic light-emitting diode OLED1 may include the first sub-pixel electrode 210R, the first intermediate layer 220R including the first common layer 221, the first emission layer 222R, and the second common layer 223, and the opposite electrode 230, the second organic light-emitting diode OLED2 may include a stack structure of the second sub-pixel electrode 210G, the second intermediate layer 220G including the first common layer 221, the second emission layer 222G, and the second common layer 223, and the opposite electrode 230, and the third organic light-emitting diode OLED3 may include the third sub-pixel electrode 210B, the third intermediate layer 220B including the first common layer 221, the third emission layer 222B, and the second common layer 223, and the opposite electrode 230.

The first opening CH1 may be disposed in the opposite electrode 230 disposed in the first emission area EA1. In addition, the second opening CH2 may be disposed in the opposite electrode 230 disposed in the second emission area EA2, and the third opening CH3 may be disposed in the opposite electrode 230 disposed in the third emission area EA3.

The capping layer 240 may be disposed on the light-emitting diode layer. At least a portion of the capping layer 240 may be disposed inside a bank opening respectively at the first to third openings CH1, CH2, and CH3. The upper planarization layer 300 may be disposed on the capping layer 240.

The upper planarization layer 300 may be disposed on the entire surface of the capping layer 240. As an example, a portion of the upper planarization layer 300 may be disposed inside a bank opening overlapping the first to third lower openings 225OP1, 225OP2, and 225OP3 of the bank layer 225. A portion of the upper planarization layer 300 disposed inside each of the bank openings at the first to third lower openings 225OP1, 225OP2, and 225OP3 may be disposed spaced apart from each other in island shapes. Another portion of the upper planarization layer 300 may be disposed on the spacer 227 and may connect portions of the upper planarization layer 300 disposed inside adjacent lower openings. Here the upper planarization layer 300 may be between the capping layer 240 and the encapsulation layer 400 along the thickness direction.

The upper planarization layer 300 may include a material equal or similar to that of the organic encapsulation layer 420. At least a portion of the upper planarization layer 300 may be disposed inside the first to third openings CH1, CH2, and CH3.

The encapsulation layer 400 including the first inorganic encapsulation layer 410, the organic encapsulation layer 420, and the second inorganic encapsulation layer 430 may be disposed on the upper planarization layer 300 and the capping layer 240. The upper planarization layer 300 may reduce bending of the first inorganic encapsulation layer 410 by approximately planarizing a surface on which the first inorganic encapsulation layer 410 is disposed.

The touch sensor layer 500 including the first touch electrode MT1, the first touch insulating layer 510, the second touch electrode MT2, and the second touch insulating layer 520 may be disposed on the encapsulation layer 400.

As shown in FIG. 15A, the anti-reflection layer 600 including the first to third color filters 620R, 620G, and 620B of different colors respectively corresponding to the first to third organic light-emitting diodes OLED1, OLED2, and OLED3, and the light-blocking layer 610 in the non-emission area, may be disposed on the touch sensor layer 500. In an embodiment, the anti-reflection layer 600 including only the first to third color filters 620R, 620G, and 620B in the non-emission area without the light-blocking layer 610may be disposed on the touch sensor layer 500 as shown in FIG. 15B. In this case, the anti-reflection layer 600 may include the light-blocking portion BP of the non-emission area including the first to third color filters 620R, 620G, and 620B which are stacked and overlapping each other.

The display device DV and the electronic device 1 including the same according to the embodiments may reduce a reflection color band due to external light.

The display device DV and the electronic device 1 including the same according to the embodiments may provide clear images.

In an embodiment, a display device DV or an electronic device 1 includes a display area DA including emission areas, display elements which are respectively in the emission areas and configured to emit light of different colors, where the display elements each includes a pixel electrode, an intermediate layer, and an opposite electrode 230 in which openings CH are defined, and an anti-reflection layer 600 on the display elements, the anti-reflection layer 600 including color filters respectively corresponding to the display elements. Within a same emission area among the emission areas, sizes or shapes of the openings CH defined in the opposite electrode 230 are different from each other together with a largest dimension of each among the openings CH which are in the same emission area being from(in a ragne of) about 1 µm to about 10 µm.

Within the same emission area, at least two openings CH may be defined in the opposite electrode 230 for the each display element.

The display device DV (or the electronic device 1) may further include an encapsulation layer 400 on the display elements, the encapsulation layer 400 including an inorganic encapsulation layer and an organic encapsulation layer 420.

The display device DV (or the electronic device 1) may further include a bank layer (like 225 and 227 together) in which bank openings (e.g., the lower openings as a lower portion of the bank opening) are defined respectively corresponding to the emission areas. The inorganic encapsulation layer or the organic encapsulation layer 420 may extend into the bank openings.

The display device DV (or the electronic device 1) may further include a capping layer 240 between the opposite electrodes 230 and the encapsulation layer 400. The capping layer 240 may extend into the openings CH of the opposite electrodes 230.

Within the same emission area, the openings CH may penetrate through the opposite electrode 230 in a thickness direction of the opposite electrode 230 and be spaced apart from each other along the same emission area.

The display device DV (or the electronic device 1) may further include an upper planarization layer 300 disposed on the opposite electrodes with the pixel electrode 230.

The opposite electrode 230 may be disposed entirely cover the display area DA.

The display area DA may further include a non-emission area adjacent to the emission areas, and the anti-reflection layer 600 may further include a light-blocking layer 610 in the non-emission area and in which opening areas are defined respectively corresponding to the display elements (or to the emission areas).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device comprising:
a display area comprising emission areas;
display elements which are respectively in the emission areas and configured to emit light of different colors, the display elements each including:
a pixel electrode,
an intermediate layer, and
an opposite electrode in which openings are defined; and
an anti-reflection layer on the display elements, the anti-reflection layer including color filters respectively corresponding to the display elements,
wherein within a same emission area among the emission areas, sizes or shapes of the openings defined in the opposite electrode are different from each other together with a largest dimension among the openings which are in the same emission area being from 1 micrometer to 10 micrometers.

2. The display device of claim 1, wherein within the same emission area, at least two openings are defined in the opposite electrode for the each display element.

3. The display device of claim 1 or 2, further comprising an encapsulation layer on the display elements, the encapsulation layer including an inorganic encapsulation layer and an organic encapsulation layer in order from the display elements.

4. The display device of claim 3, further comprising a bank layer in which bank openings are defined respectively corresponding to the emission areas,
wherein the organic encapsulation layer or the inorganic encapsulation layer extends into the bank openings.

5. The display device of claim 3 or 4, further comprising a capping layer between each of the opposite electrodes and the encapsulation layer, respectively.

6. The display device of claim 5, wherein the capping layer extends into the openings of each of the opposite electrodes.

7. The display device of any one of claims 1 to 6, wherein within the same emission area, the openings penetrate through a thickness of the opposite electrode and are spaced apart from each other along the same emission area.

8. The display device of any one of claims 1 to 7, further comprising an upper planarization layer facing the opposite electrodes with the pixel electrodes and the intermediate layers therebetween, respectively.

9. The display device of any one of claims 1 to 8, wherein the opposite electrode extends from the display elements to entirely cover the display area.

10. The display device of any one of claims 1 to 9, wherein
the display area further comprises a non-emission area adjacent to the emission areas; and
the anti-reflection layer further includes a light-blocking layer in the non-emission area and in which opening areas are defined respectively corresponding to the display elements.

11. An electronic device comprising a display device as claimed in any one of claims 1 to 10.
